# EUROPÄISCHE PATENTSCHRIFT

(11) **EP 3 104 446 B1**
(45) Veröffentlichungstag und Bekanntmachung des Hinweises auf die Patenterteilung: **02.03.2022**
(21) Anmeldenummer: 15171858.2
(22) Anmeldetag: 12.06.2015
(51) Int. Cl.: H01M 10/44, G01R 31/36

(54) **VERFAHREN ZUM BETRIEB EINES WIEDERAUFLADBAREN SPEICHERSYSTEMS FÜR ELEKTRISCHE ENERGIE SOWIE VORRICHTUNG ZUR KONTROLLE UND DURCHFÜHRUNG DES LADEVORGANGS DES SPEICHERSYSTEMS**
METHOD FOR OPERATING A RECHARGEABLE STORAGE SYSTEM FOR ELECTRICAL ENERGY AND DEVICE FOR CONTROLLING AND EXECUTING THE CHARGING PROCESS OF THE STORAGE SYSTEM
PROCÉDÉ DE FONCTIONNEMENT D'UN SYSTÈME DE STOCKAGE RECHARGEABLE D'ÉNERGIE ÉLECTRIQUE ET DISPOSITIF DE CONTRÔLE ET D'EXÉCUTION DU CHARGEMENT DU SYSTÈME DE CHARGE

(43) Veröffentlichungstag der Anmeldung: 14.12.2016
(73) Patentinhaber: VARTA Microbattery GmbH, 73479 Ellwangen Jagst (DE)
(72) Erfinder: Ensling, David, 73479 Ellwangen (DE); Gottschalk, Michael, 73433 Aalen (DE); Pytlik, Edward, 73479 Ellwangen (DE); Röger, Günter, 74589 Satteldorf (DE)
(74) Vertreter: Ostertag & Partner Patentanwälte mbB

(56) Entgegenhaltungen:
- DE-A1- 10 312 591
- US-A1- 2003 030 414
- US-A1- 2007 182 418
- US-A1- 2010 164 437
- US-A1- 2015 030 891

## Beschreibung

Gegenstand der Erfindung ist ein Verfahren zum Betrieb eines wiederaufladbaren Speichersystems für elektrische Energie, das mindestens eine elektrochemische Zelle mit wässrigem Elektrolyten umfasst. Weiterhin betrifft die Erfindung eine Vorrichtung zur Kontrolle und Durchführung eines Ladevorgangs eines solchen Speichersystems.

Wiederaufladbare Speichersysteme für elektrische Energie (sogenannte sekundäre Speichersysteme oder Akkumulatoren), die einen wässrigen Elektrolyten aufweisen, sind bereits seit Langem bekannt. Bekannte Beispiele für klassische Akkumulatoren sind der Nickel-Eisen-Akkumulator (Edison-Akkumulator), der Nickel-Metallhydrid-Akkumulator, der Nickel-Zink-Akkumulator und der Nickel-Cadmium-Akkumulator. Diese weisen als Elektrolyten eine wässrige alkalische Lösung, meist Natronlauge oder Kalilauge, auf.

Jüngere Entwicklungen der Anmelderin, beschrieben in der WO 2016/005528 A2 und in der WO 2016/020136 A2, betreffen unter anderem Nickel-Eisen-Akkumulatoren und Nickel-Metallhydrid-Akkumulatoren, deren negative Elektroden mit einem kohlenstoffbasierten Speichermaterial modifiziert sind, so dass sie pseudokapazitive Eigenschaften aufweisen. Diese Akkumulatoren zeichnen sich insbesondere dadurch aus, dass sie sich sehr schnell Laden lassen und dabei eine hohe Überladestabilität aufweisen. Auch hier kommen wässrige, alkalische Elektrolyte zum Einsatz.

Da Wasser eine relativ niedrige Zersetzungsspannung aufweist, muss im Betrieb bei Speichersystemen mit wässrigem Elektrolyten verstärkt darauf geachtet werden, dass es nicht zu einer unerwünschten Gasentwicklung in Folge von Elektrolytzersetzung kommt. Entsprechende Vorsichtsmaßnahmen müssen insbesondere bei Ladevorgängen getroffen werden.

Aus der US 2015/030891 A1 ist es bekannt, beim Betrieb alkalischer Batterien das Spannungsfenster zwischen Lade- und Entladeendspannung sehr eng zu halten, mit dem Ziel, primäre Batterien als wieder aufladbare Batterien zu betreiben. Akkumulatoren, die Elektroden mit pseudokapazitiven Eigenschaften aufweisen, sind aus diesem Dokument nicht bekannt.

Aus der US 2003/030414 A1 ist es bekannt, den Alterungsstatus wiederaufladbarer Batterien zu ermitteln. Hierzu wird der innere Widerstand der Batterien ermittelt. Darüber hinaus kann es vorgesehen sein, weiterhin auch die Temperatur der Batterien zu ermitteln. Falls diese sich außerhalb eines vorbestimmten Bereichs befindet, wird ein Alarmsignal ausgelöst. Das Ergebnis der Temperaturmessung wirkt sich nicht unmittelbar auf Betriebsparameter der Batterien wie Lade- oder Entladeendspannungen aus.

Der vorliegenden Erfindung lag die Aufgabe zugrunde, ein Betriebsverfahren für Speichersysteme mit wässrigem Elektrolyten bereitzustellen, das dieses Problem umfassend adressiert. Besonderes Augenmerk sollte hierbei auf die Entwicklung eines Betriebsverfahrens gelegt werden, das eine hohe Lebensdauer von Speichersystemen mit wässrigem Elektrolyten gewährleistet, deren negative Elektroden pseudokapazitive Eigenschaften aufweisen.

Diese Aufgabe wird gelöst durch das Verfahren mit den Merkmalen des Anspruchs 1 sowie die Vorrichtung mit den Merkmalen des Anspruchs 15. Bevorzugte Ausführungsformen des erfindungsgemäßen Verfahrens sind in den abhängigen Ansprüchen 2 bis 14 angegeben. Der Wortlaut sämtlicher Ansprüche wird hiermit durch Bezugnahme zum Inhalt der vorliegenden Beschreibung gemacht.

Das erfindungsgemäße Verfahren eignet sich grundsätzlich für alle Speichersysteme, die mindestens eine elektrochemische Zelle mit wässrigem Elektrolyten, bevorzugt mit einem wässrigen alkalischen Elektrolyten, umfassen. Hierzu zählen die eingangs genannten bekannten Ackumulatoren. Insbesondere zählen dazu aber auch die erwähnten Speichersysteme, deren Elektroden pseudokapazitive Eigenschaften aufweisen. Für diese Systeme ist das erfindungsgemäße Verfahren von besonderer Bedeutung, da sie in der Regel bei höheren Spannungen betrieben werden als vergleichbare klassische Akkumulatoren. Besonders bevorzugte Systeme sind am Ende dieser Beschreibung ausführlich erläutert.

Die im Rahmen des erfindungsgemäßen Verfahrens betreibbaren Speichersysteme umfassen in aller Regel mehr als eine elektrochemische Zelle. Bevorzugt weisen sie zwei oder mehr Zellen auf, die in Reihe und/oder parallel zueinander geschaltet sind.

Das erfindungsgemäße Verfahren zeichnet sich insbesondere durch eine Kombination von Einzelschritten aus, die beim Laden des Speichersystems Anwendung finden. Zum Laden werden
- eine Zielspannung Uz festgelegt,
- ein Korrekturfaktor (oder Korrekturwert) K1 für die Zielspannung Uz bestimmt, der vom Alterungszustand (sogenannter "state of health" - kurz: SOH) der mindestens einen elektrochemischen Zelle abhängt,
- ein Korrekturfaktor (oder Korrekturwert) K2 für die Zielspannung Uz bestimmt, der von der Umgebungstemperatur und/oder der Temperatur des Speichersystems oder einer Komponente des Speichersystems abhängt,
- die bestimmten Korrekturfaktoren K1 und/oder K2 auf die Zielspannung Uz zwecks Ermittlung einer korrigierten Zielspannung U_{ZK} angewendet und
- das Speichersystem bei einem Ladestrom und einer Ladespannung geladen, bis die Zielspannung U_{ZK} an dem Speichersystem erreicht wird.

### Korrektur der Zielspannung Uz

Auf den Ladevorgang eines Speichersystems für elektrische Energie nehmen zwei Faktoren besonders großen Einfluss. Der wichtigste Faktor ist meist die Temperatur. Wenn diese einen kritischen Wert überschreitet, so ist es leicht möglich, dass ein Speichersystem ungewollt überladen wird und dabei Schaden nimmt. Es ist daher nicht unüblich, Ladeparameter wie die Ladespannung und den Ladestrom in Abhängigkeit der aktuellen Temperatur eines zu ladenden Speichersystems zu ändern.

Ein dafür geeignetes Verfahren ist beispielsweise aus der EP 2 259 404 A1 bekannt.

Bei dem erfindungsgemäßen Verfahren wird die Temperatur über den Faktor K2 berücksichtigt. Darüber hinaus werden aber zusätzlich Änderungen der Ladeparameter in Abhängigkeit des Alterungszustands des Speichersystems vorgenommen. Mit fortschreitender Lebensdauer des Speichersystems erhöht sich in Folge ungewollter Neben- und Zersetzungsreaktionen sein Innenwiderstand. Das führt dazu, dass beim Laden bei unveränderten Ladeparametern die obere Kapazitätsgrenze des Speichersystems nicht mehr erreicht wird. Dem wird erfindungsgemäß durch Anwenden des Korrekturfaktors K1 entgegengewirkt.

Initial wird die Zielspannung U_{z} bevorzugt auf einen Wert knapp oberhalb der Nominalspannung des jeweils zu ladenden Speichersystems eingestellt. Besonders bevorzugt beträgt die Zielspannung U_{z} 101 % bis 102,5 % der Nominalspannung. Wenn also beispielsweise ein Speichersystem mit wässrigem Elektrolyten eine Nominalspannung von 1,4 V aufweist, so ist es bevorzugt, die Zielspannung U_{z} auf einen Wert von 1,01 * 1,4 V bis 1,025 * 1,4 V, also beispielsweise auf 1,43 V, einzustellen. Sind zwei in Reihe geschaltete Zellen mit einer Nominalspannung von jeweils 1,4 zu laden, so wird U_{z} bevorzugt auf einen Wert von 1,01 * 2,8 V bis 1,025 * 2,8 V, also beispielsweise auf 2,86 V, eingestellt.

Die beiden Korrekturfaktoren K1 und K2 können in grundsätzlich beliebiger Reihenfolge auf die Zielspannung U_{z} angewendet werden, wobei in den meisten Fällen bevorzugt zuerst K2 angewandt wird. Grundsätzlich lassen sich dimensionslose Korrekturfaktoren wie K1 und K2 auch in Form konkreter Korrekturwerte [V] ausdrücken, die zur Zielspannung addiert oder von dieser abgezogen werden. In welcher Abfolge dies geschieht, spielt in der Praxis ebenfalls keine Rolle.

Selbstverständlich kann jeder der Korrekturfaktoren auch 1 sein, so dass die Zielspannung U_{z} gegebenenfalls keiner Anpassung bedarf (U_{z} = U_{ZK}). In aller Regel tritt dieser Fall allerdings nur bei Speichersystemen auf, bei denen Alterungsprozesse noch nicht in signifikantem Maß stattgefunden haben. Weiterhin ist es auch möglich, dass sich die beiden Korrekturfaktoren in ihrer Wirkung aufheben (auch hier resultiert dann U_{z} = U_{ZK}).

### Bestimmung von K1

Die Bestimmung von K1 kann anhand einer oder mehrerer Messungen vor und/oder während des Ladevorgangs erfolgen. Die Ergebnisse dieser Messung oder dieser Messungen können mit Vergleichsdaten abgeglichen werden. Aus diesem Abgleich ergibt sich, ob und in welchem Umfang sich eine oder mehrere Eigenschaften des Speichersystems seit einer vorhergehenden Bestimmung geändert haben.

Bei den Vergleichsdaten handelt es sich beispielsweise um Messergebnisse, die bei einem initialen Ladevorgang gemessen wurden, oder um Erfahrungswerte. Um eine besonders hohe Aussagekraft zu erreichen, kann es bevorzugt sein, bei den ersten Ladevorgängen nach Inbetriebnahme eines Speichersystems mehrere Messwerte zu bestimmen und aus diesen einen Mittelwert zu bilden, der dann als initialer Referenzwert dient oder aus dem ein initialer Referenzwert abgeleitet werden kann. Zur Bestimmung von K1 können die Ergebnisse von Folgemessungen ins Verhältnis zu diesem Referenzwert gesetzt werden.

Die Bestimmung von K1 muss nicht zwingend bei jedem Ladevorgang erfolgen. In aller Regel ändert sich der Alterungszustand eines Speichersystems zwischen unmittelbar aufeinanderfolgenden Lade- und Entladezyklen nicht signifikant, so dass es ausreichend sein kann, K1 nur in Intervallen, beispielsweise in Abständen von 10 Ladezyklen, zu aktualisieren. Mit anderen Worten, innerhalb des Intervalls wird bei jedem Ladevorgang der gleiche Korrekturfaktor K1 auf die Zielspannung U_{z} angewendet. Die Länge der Intervalle kann variieren. In aller Regel ist es sinnvoll, die Intervalle mit fortschreitendem Alter des Speichersystems zu verkürzen, da die Geschwindigkeit, mit dem sich seine Eigenschaften ändern, insbesondere bei fortgeschrittenem Alter auch nicht linear ansteigen kann.

Es gibt unterschiedliche Eigenschaften, die als Indikatoren für den Alterungszustand eines Speichersystems für elektrische Energie dienen können. Erfindungsgemäß ist es bevorzugt, dass zur Bestimmung von K1 mindestens eine der folgenden Eigenschaften des Speichersystems untersucht wird:
- ein Widerstand oder eine Widerstandsänderung des Speichersystems oder einer Komponente des Speichersystems,
- eine Leitfähigkeit oder eine Leitfähigkeitsänderung des Speichersystems oder einer Komponente des Speichersystems,
- eine Kapazität oder eine Kapazitätsänderung des Speichersystems oder einer Komponente des Speichersystems, und
- eine Temperatur oder eine Temperaturänderung des Speichersystems oder einer Komponente des Speichersystems bei definierten Lade- und/oder Entladebedingungen.

Bei der erwähnten Komponente des Speichersystems kann es sich insbesondere um eine einzelne elektrochemische Zelle oder um eine Elektrode einer elektrochemischen Zelle handeln.

Bevorzugt wird untersucht, ob sich der Innenwiderstand des Speichersystems geändert hat. Der Innenwiderstand kann bestimmt werden, wie das unter Punkt 7.10.2 der deutschen Norm DIN EN 61951-2 beschrieben ist.

Besonders bevorzugt wird zur Bestimmung von K1 eine Entladung, insbesondere eine Pulsentladung, des Speichersystems oder der Komponente des Speichersystems herbeigeführt, wobei ein Spannungsabfall dU (die Differenz zwischen der Ausgangsspannung des Speichersystems zum Zeitpunkt 0 der Entladung und der gemessenen Spannung nach einer definierten Entladezeit) gemessen wird. Zwecks unmittelbarer Bestimmung von K1 kann dU ins Verhältnis zu einem Spannungsabfall aus einer vorhergehenden Messung (beispielsweise dem oben erwähnten Referenzwert) gesetzt werden (dU / dUᵢₙᵢₜᵢₐₗ).

Alternativ kann zunächst über das Ohmsche Gesetz aus dem gemessenen Spannungsabfall dU der Innenwiderstand des Speichersystems oder der Komponente des Speichersystems abgeleitet werden. Der aus dU abgeleitete Innenwiderstand kann dann zwecks Bestimmung von K1 ins Verhältnis zu einem zuvor auf analoge Weise bestimmten Vergleichswiderstand gesetzt werden.

Je älter das Speichersystem ist, desto größer fallen in aller Regel der Spannungsabfall und damit auch ein daraus abgeleiteter Widerstand aus. Damit sich Messergebnisse mit zuvor bestimmten Werten, beispielsweise dem initialen Referenzwert, gut vergleichen lassen, sollten allerdings die Parameter bei allen durchgeführten Messungen vergleichbar sein. Vorzugsweise erfolgen die Messungen unter Beachtung der Parameter
- Temperatur,
- Ladezustand ("state of charge" - kurz: SOC),
- Entladestrom,
- Ausgangsspannung zum Zeitpunkt 0 der Entladung und
- Entladedauer.

Idealerweise sind diese Parameter bei allen Vergleichsmessungen identisch oder weichen nur geringfügig voneinander ab. Damit beispielsweise eine jüngere K1-Bestimmung vergleichbar mit einer älteren K1-Bestimmung ist, sollte die jüngere K1-Bestimmung bei einer Temperatur erfolgen, die nicht mehr als ± 2 °C von der Temperatur abweichen, bei der die ältere K1-Bestimmung erfolgt ist.

Bevorzugt liegen die Temperatur des Speichersystems und/oder die Umgebungstemperatur bei der Messung des Spannungsabfalls im Bereich von 20 °C bis 40 °C, besonders bevorzugt im Bereich von 22 °C bis 26 °C.

Der Ladezustand des Speichersystems liegt bei der Messung bevorzugt im Bereich von 55 % bis 100 %, allerdings abhängig vom Typ des Speichersystems. Für Speichersysteme, die im Kraftfahrzeugbereich zum Einsatz kommen, liegt der Ladezustand vorzugsweise im Bereich von 60 % bis 70 %. Für Speichersysteme, die im elektronischen Bereich zum Einsatz kommen, insbesondere als Back-up-Speichersysteme, liegt der Ladezustand vorzugsweise im Bereich von 60 % bis 70 %.

Für den Entladestrom und die Ausgangsspannung gelten bei der Messung bevorzugte Bereiche von 0,5 C bis 10 C, insbesondere von 5 C bis 10 C, sowie von 1,1 V bis 1,35 V. Abhängig vom Typ des Speichersystems gelten für die Ausgangsspannung innerhalb des genannten Intervalls weiter bevorzugte Werte: Für Speichersysteme, die im Kraftfahrzeugbereich zum Einsatz kommen, wird für die Ausgangsspannung vorzugsweise ein Wert im Bereich von 1,1 V bis 1,25 V gewählt. Für Speichersysteme die im elektronischen Bereich zum Einsatz kommen insbesondere als Back-up-Speichersysteme, wird für die Ausgangsspannung vorzugsweise ein Wert im Bereich von 1,27 V bis 1,35 V gewählt.

Die Entladedauer liegt bevorzugt im Bereich von 5 ms bis 500 ms, insbesondere im Bereich von 10 ms bis 100 ms.

In bevorzugten Ausführungsformen kann die Temperatur des Speichersystems oder einer seiner Komponenten vor einer Messung gezielt auf einen bestimmten Wert, insbesondere auf einen Wert innerhalb des genannten bevorzugten Bereichs, eingestellt werden. Hierzu können gegebenenfalls Heiz- und Kühlmittel vorgesehen sein. Bevorzugt erfolgt die Messung erst nach einer Relaxationsphase. In einigen bevorzugten Ausführungsformen beträgt diese nach Abschluss eines Ladevorgangs zwischen 1 h und 10 h, insbesondere zwischen 5 h und 8h. Sie kann aber ohne weiteres auch mehrere Tage betragen.

Der Korrekturfaktor K1 ist in aller Regel ein Wert > 1. Üblich sind Werte im Bereich von von 1 bis 1,2, insbesondere im Bereich von 1 bis 1,1. Durch Anwendung von K1 wird die Zielspannung üblicherweise also erhöht.

### Bestimmung von K2

Die Bestimmung des Korrekturfaktors K2 und das Anwenden desselben auf die Zielspannung U_{z} erfolgt bevorzugt während des Ladens, vorzugsweise kontinuierlich oder in zwei oder mehr Einzelschritten. Es ist üblich, dass sich die Temperatur eines Speichersystems während des Ladens verändert. Es ist daher zweckmäßig, die Temperatur des Speichersystems und/oder die Umgebungstemperatur während des Ladevorgangs zu überwachen und gegebenenfalls K2 auch während eines Ladeverfahrens anzupassen.

Bevorzugt werden im Rahmen des erfindungsgemäßen Verfahrens ein oberer Temperaturschwellenwert für die Umgebungstemperatur und/oder ein oberer Temperaturschwellenwert für die Temperatur des Speichersystems oder einer Komponente des Speichersystems festgelegt. Bevorzugt ist der obere Temperaturschwellenwert für die Umgebungstemperatur identisch mit dem oberen Temperaturschwellenwert für die Temperatur des Speichersystems oder der Komponente des Speichersystems.

Bevorzugt werden im Rahmen des erfindungsgemäßen Verfahrens weiterhin ein unterer Temperaturschwellenwert für die Umgebungstemperatur und/oder ein unterer Temperaturschwellenwert für die Temperatur des Speichersystems oder einer Komponente des Speichersystems festgelegt. Bevorzugt ist der untere Temperaturschwellenwert für die Umgebungstemperatur identisch mit dem unteren Temperaturschwellenwert für die Temperatur des Speichersystems oder der Komponente des Speichersystems.

Wird bei einer anschließenden Messung einer der oberen oder der unteren Schwellenwerte überschritten oder unterschritten, so kann K2 aus der Differenz zwischen dem Schwellenwert und der gemessenen Temperatur mittels einer Korrekturformel errechnet oder einer Korrelationstabelle entnommen werden.

Es ist bevorzugt, dass bei Überschreiten eines der oberen Temperaturschwellenwerte die Zielspannung U_{z} abgesenkt wird, insbesondere um einen Wert im Bereich von -1,2 mV bis -1,8 mV je °C Überschreitung. K2 ergibt sich in diesem Fall aus einer Multiplikation des angegebenen mV-Wertes mit der Differenz zwischen der gemessenen Temperatur und dem Temperaturschwellenwert.

Es ist weiterhin bevorzugt, dass bei Unterschreiten eines der unteren Temperaturschwellenwerte die Zielspannung U_{z} angehoben wird, insbesondere um einen Wert im Bereich von +1,2 mV bis +1,8 mV je °C Unterschreitung. K2 ergibt sich in diesem Fall aus einer Multiplikation des angegebenen mV-Wertes mit der Differenz zwischen der gemessenen Temperatur und dem Temperaturschwellenwert.

In einigen bevorzugten Ausführungsformen ist es vorgesehen, dass das Überschreiten eines der oberen Temperaturschwellenwerte Auswirkungen auf die Korrektur der Zielspannung Uz mittels K1 hat. Während die Anwendung von K1 in aller Regel zu einer Anhebung der Ladespannung führt, wirkt die Anwendung von K2 im Falle des Überschreitens eines der oberen Temperaturschwellenwerte in die entgegengesetzte Richtung. Im Hinblick auf den Faktor Betriebssicherheit ist K2 von grundsätzlich größerer Bedeutung als K1. Während die Nichtanwendung von K1 lediglich dazu führen kann, dass ein Speichersystem nicht seine volle Kapazität erreicht, kann die Nichtanwendung des zweiten Korrekturfaktors im Extremfall zu einer Schädigung des Speichersystems führen. In bevorzugten Ausführungsformen ist es daher vorgesehen, dass bei Überschreitung eines der oberen Temperaturschwellenwerte ein gegebenenfalls zuvor bestimmter Korrekturfaktor K1 nicht angewendet oder auf 1 gesetzt wird.

Die oberen Temperaturschwellenwerte werden bevorzugt im Bereich von 45 °C bis 80 °C, bevorzugt im Bereich von 45 °C bis 60 °C, gewählt.

Die unteren Temperaturschwellenwerte werden bevorzugt im Bereich von 10 °C bis - 10 °C gewählt.

Das Laden des Speichersystems bis zum Erreichen der Zielspannung U_{zk} wird bevorzugt bei einem konstanten Ladestrom Iₖ (constant current) durchgeführt. Dabei ist es bevorzugt, dass der Ladestrom Iₖ auf einen Wert im Bereich von 0,5 bis 10 C, insbesondere im Bereich von 0,5 bis 2 C, eingestellt wird (0,5 C bedeutet, dass der Ladestrom der halben Nennkapazität entspricht, die Ladezeit theoretisch also 2 Stunden betragen sollte. 2 C bedeutet, dass der Ladestrom der doppelten Nennkapazität entspricht, die Ladezeit theoretisch also 0,5 Stunden betragen sollte).

Gleichermaßen kann es bevorzugt sein, an Stelle der Ladung bei konstantem Ladestrom Iₖ eine Konstantspannungsladung bei einer konstanten Spannung U_{K}, durchzuführen, bis die Zielspannung U_{zk} erreicht ist. Die Ladespannung wird dann bevorzugt auf einen Wert ≥ U_{zk} eingestellt.

Für den Fall, dass beispielsweise aufgrund eines Fehlers die Zielspannung U_{zk} beim Laden mit der konstanten Spannung U_{K1} nicht erreicht wird, ist es in bevorzugten Ausführungsformen vorgesehen, die Konstantspannungsladung zeitlich zu begrenzen. Das Laden wird dann also abgebrochen, ohne dass die Zielspannung U_{zk} erreicht ist.

Unabhängig davon, ob die Zielspannung U_{zk} durch Laden mit konstantem Ladestrom Iₖ oder durch Laden mit konstanter Spannung U_{K1} erreicht wurde, ist es bevorzugt, dass das Laden des Speichersystems nach Erreichen der Zielspannung U_{zk} bei einer konstanten Spannung Uₖ₂ fortgesetzt wird (Erhaltungsladung). Die Spannung Uₖ₂ wird bevorzugt in Pulsform bereitgestellt.

### Korrektur der Entladeschlussspannung U_{ES}

In besonders bevorzugten Ausführungsformen des erfindungsgemäßen Verfahrens werden zum Laden des Speichersystems zusätzlich
- eine Entladeschlussspannung U_{ES} festgelegt,
- ein Korrekturfaktor K3 für die Entladeschlussspannung U_{ES} bestimmt, der vom Alterungszustand (SOH) der mindestens einen elektrochemischen Zelle abhängt,
- der bestimmte Korrekturfaktor K3 auf die Entladeschlussspannung U_{ES} zwecks Ermittlung einer korrigierten Entladeschlussspannung U_{ESK} angewendet und
- das Laden des Speichersystems initiiert, wenn die korrigierte Entladeschlussspannung U_{ESK} an dem Speichersystem erreicht wird.

K3 lässt sich bestimmen wie K1. Eine separate Bestimmung ist in der Regel nicht erforderlich, da sich K3 für ein bekanntes System aus K1 ableiten lässt. In einem Spezialfall (Ladestrom = Entladestrom) ist K3 beispielsweise der Kehrwert von K1, ergibt sich also unmittelbar aus K1. Hieraus folgt weiterhin, dass K3 in aller Regel < 1 ist. Üblich sind Werte im Bereich von 0,1 bis 1, bevorzugt im Bereich von 0,6 bis 1, insbesondere im Bereich von 0,9 bis 1. Durch Anwendung von K1 wird U_{ESK} üblicherweise also erniedrigt. Mit fortschreitendem Alter des Speichersystems wird die Differenz zwischen der korrigierten Entladeschlussspannung und der korrigierten Zielspannung somit immer größer.

Wie K1 und K2 ist auch K3 dimensionslos, lässt sich aber natürlich ebenfalls in Form eines konkreten Korrekturwerts [V] ausdrücken, die zur Zielspannung addiert oder von dieser abgezogen wird.

Es ist zu betonen, dass die Korrektur der Entladeschlussspannung U_{ES} ein Aspekt des erfindungsgemäßen Verfahrens ist, der grundsätzlich auch völlig unabhängig zur Anwendung kommen kann, also auch ohne eine begleitende Korrektur der Zielspannung. In einer Sonderform des erfindungsgemäßen Verfahrens wird somit lediglich die Entladeschlussspannung korrigiert, nicht jedoch die Zielspannung.

Das Anwenden eines temperaturabhängigen Korrekturfaktors auf die Entladeschlussspannung U_{ES} ist nicht zwingend erforderlich. Primär wird durch die Anwendung von K2 lediglich die beschriebene Überladungsproblematik adressiert, die im Bereich der Entladeschlussspannung keine Rolle spielt. Allerdings kann K2 bei tiefen Temperaturen eine Rolle spielen, also bei Unterschreiten des oben beschriebenen unteren Temperaturschwellenwerts für die Umgebungstemperatur und/oder des unteren Temperaturschwellenwerts für die Temperatur des Speichersystems oder einer Komponente des Speichersystems.

Es ist bevorzugt, dass für die Zielspannung U_{zk} und/oder die korrigierte Entladeschlussspannung U_{ESK} Schwellenwerte festgelegt werden, die im Betrieb des Speichersystems nicht überschritten bzw. unterschritten werden sollen. Wie oben ausgeführt, bewirkt beispielsweise K1 in aller Regel eine Erhöhung der Zielspannung. Selbstverständlich darf diese Erhöhung nicht beliebig groß sein, da es ansonsten zu einer Schädigung der Zelle, beispielsweise infolge einer Elektrolytzersetzung, kommen kann. Es ist daher bevorzugt, dass, sofern die Anwendung eines Korrekturfaktors zu einer Über- oder Unterschreitung der genannten Schwellenwerte führen würde, eine Korrektur nur bis zum Erreichen des Schwellenwerts vorgenommen wird.

### Vorrichtung zur Kontrolle und Durchführung des Ladevorgangs

Die vorliegende Erfindung betrifft weiterhin eine Vorrichtung zur Kontrolle und Durchführung des Ladevorgangs eines Speichersystems für elektrische Energie, das mindestens eine elektrochemische Zelle mit wässrigem Elektrolyten umfasst. Die Vorrichtung umfasst bevorzugt
- Ein Mittel zum Festlegen einer Zielspannung Uz
   und/oder
   ein Mittel zum Festlegen einer Entladeschlussspannung U_{ES},
- Ein Mittel zur Bestimmung eines Korrekturfaktors K1 für die Zielspannung Uz, der vom Alterungszustand (SOH) des zu ladenden Speichersystems abhängt,
   und
   ein Mittel zur Bestimmung eines Korrekturfaktors K2 für die Zielspannung Uz, der von der Umgebungstemperatur und/oder der Temperatur der zu ladenden Speichersystems oder einer Komponente des Speichersystems abhängt,
   und/oder
   ein Mittel zur Bestimmung eines Korrekturfaktors K3 für die Entladeschlussspannung U_{ES}, der vom Alterungszustand (SOH) des zu ladenden Speichersystems abhängt,
- Ein Mittel zum Anwenden der ermittelten Korrekturfaktoren K1 und/oder K2 auf die Zielspannung Uz zwecks Ermittlung einer korrigierten Zielspannung U_{ZK},
   und/oder
   ein Mittel zum Anwenden des ermittelten Korrekturfaktors K3 auf die Entladeschlussspannung U_{ES} zwecks Ermittlung einer korrigierten Entladeschlussspannung U_{ESK}, und
- Ein Mittel zum Laden des Speichersystems, bis die Zielspannung U_{ZK} an der Zelle erreicht wird und/oder wenn die korrigierte Entladeschlussspannung U_{ESK} an dem Speichersystem erreicht wird.

In bevorzugten Ausführungsformen umfasst die Vorrichtung einen Mikrocontroller einschließlich eines Datenspeichers. Der Mikrocontroller kontrolliert und steuert den Ladevorgang. In dem Datenspeicher können Werte für die Zielspannung Uz und/oder für die Entladeschlussspannung U_{ES} abgelegt werden. Bei Bedarf, insbesondere zum Festlegen der Zielspannung Uz und/oder der Entladeschlussspannung U_{ES}, können diese Werte vom Mikrocontroller abgerufen und verarbeitet werden.

Das Mittel zur Bestimmung von K1 umfasst bevorzugt einen Spannungsmesser, mit dem der zur Bestimmung des Innenwiderstands eingeleitete Spannungsabfall dU detektiert werden kann. Die gemessenen Spannungswerte können an den erwähnten Mikrocontroller weitergeleitet und von diesem verarbeitet werden. Es ist ohnehin bevorzugt, dass in dem Datenspeicher, der dem Mikroprozessor zugeordnet ist, Messwerte aus früheren Messungen des Spannungsabfalls, gegebenenfalls auch der im Rahmen des erfindungsgemäßen Verfahren erläuterte initiale Referenzwert, gespeichert sind.

Die Mittel zur Bestimmung von K2 umfassen bevorzugt mindestens einen Temperatursensor, der thermisch mit der Umgebung des Speichersystems oder dem Speichersystem selbst oder einer Komponente des Speichersystems gekoppelt ist. Die gemessenen Temperaturwerte werden bevorzugt ebenfalls an den erwähnten Mikrocontroller weitergeleitet und von diesem verarbeitet. Weiterhin ist es bevorzugt, dass in dem Datenspeicher, der dem Mikroprozessor zugeordnet ist, Messwerte aus früheren Temperaturmessungen sowie weiterhin auch die oben angesprochenen Temperaturschwellenwerte sowie die bei Überschreitung mindestens eines der Schwellenwerte je °C Überschreitung anzuwendenden Korrekturwerte hinterlegt sind.

Das Mittel zur Bestimmung von K3 umfasst wie das Mittel zur Bestimmung von K1 bevorzugt einen Spannungsmesser, mit dem der zur Bestimmung des Innenwiderstands eingeleitete Spannungsabfall dU detektiert werden kann. Bevorzugt sind das Mittel zur Bestimmung von K3 und das Mittel zur Bestimmung von K1 identisch.

Die eigentliche Bestimmung von K3 erfolgt wie im Fall von K1 bevorzugt durch den Mikrocontroller.

In bevorzugten Ausführungsformen dient der Mikrocontroller auch als Mittel zum Anwenden der ermittelten Korrekturfaktoren K1 und/oder K2 und/oder als Mittel zum Anwenden des ermittelten Korrekturfaktors K3.

Das Mittel zum Laden des Speichersystems dient bevorzugt ein Ladecontroller, der dazu in der Lage ist, sowohl eine Konstantspannungsladung als auch eine Ladung bei konstantem Strom durchzuführen. Gegebenenfalls kann der Mikrocontroller auch diese Funktionen übernehmen.

### Geeignete Speichersysteme für elektrische Energie

Nachfolgend werden nun die Speichersysteme beschrieben, für die das beschriebene Verfahren sowie die beschriebene Vorrichtung besonders geeignet sind.

Gemeinsam ist den Speichersystemen mindestens eine elektrochemische Zelle, die eine negative Elektrode, eine positive Elektrode, einen porösen Separator, der die negative und die positive Elektrode voneinander trennt, einen wässrigen alkalischen Elektrolyten, mit dem die Elektroden und der Separator getränkt sind und ein Gehäuse, das die Elektroden, den Separator und den Elektrolyten umschließt, aufweist. Die elektrochemische Zelle ist eine sekundäre elektrochemische Zelle. Mit anderen Worten, Lade- und Entladevorgänge sind reversibel.

Die negative Elektrode der elektrochemischen Zelle gibt es in mehreren Ausführungsformen:
Variante 1 - Zur Ausbildung einer elektrischen Doppelschicht befähigte negative Elektrode
   Die negative Elektrode umfasst einen Stromableiter sowie ein kohlenstoffbasiertes Speichermaterial, das die Speicherung von elektrischer Ladung in der Elektrode durch Ausbildung einer elektrischen Doppelschicht (Helmholtz-Doppelschicht) ermöglicht.
Variante 2 - Negative Elektrode mit Pseudokapazität
   In dieser Ausführungsform umfasst die Elektrode neben einem Stromableiter und einem kohlenstoffbasierten Speichermaterial, das die Speicherung von elektrischer Ladung in der Elektrode durch Ausbildung der erwähnten elektrischen Doppelschicht ermöglicht, ein nicht kohlenstoffbasiertes Speichermaterial, das Wasserstoff chemisorbieren und/oder in Form eines Metallhydrids speichern kann (im Folgenden als H2-Speichermaterial bezeichnet).
Variante 3 - Negative Elektrode mit Pseudokapazität
   In dieser Ausführungsform enthält die Elektrode neben einem Stromableiter und einem kohlenstoffbasierten Speichermaterial, das die Speicherung von elektrischer Ladung in der Elektrode durch Ausbildung der erwähnten elektrischen Doppelschicht ermöglicht, (und alternativ zu dem nicht kohlenstoffbasierten Speichermaterial gemäß Variante 2) Eisen in metallischer (Oxidationsstufe 0) und/oder oxidierter Form (Oxidationsstufe 2 oder 3). Wenn das Eisen oxidiert vorliegt, so liegt es bevorzugt als Eisenhydroxid in der Elektrode vor. Wie den eingangs dargestellten Gleichungen zu entnehmen ist, verschiebt sich beim Laden und Entladen das Gleichgewicht zwischen der oxidierten und der metallischen Form.

Beim Vorliegen einer Kombination aus dem kohlenstoffbasierten Speichermaterial und dem nicht kohlenstoffbasierten H2-Speichermaterial oder dem Eisen (Varianten 2 und 3) vermag die negative Elektrode elektrische Ladung nicht nur durch Ausbildung der erwähnten Doppelschicht zu speichern. Vielmehr kann elektrische Ladung auch chemisch auf dem Umweg über eine reversible Redoxreaktion gespeichert werden. Kurzum: In diesen Fällen kann die negative Elektrode pseudokapazitive Eigenschaften aufweisen.

Die positive Elektrode der elektrochemischen Zelle enthält ebenfalls einen Stromableiter. Darüber hinaus enthält sie Nickelhydroxid (Ni(OH)₂) und/oder Nickeloxyhydroxid (NiO(OH)).

Beim Laden der positiven Elektrode wandelt sich Nickelhydroxid unter Aufnahme eines Hydroxid-Ions und unter Abgabe eines Wassermoleküls und Elektronen in Nickeloxyhydroxid um. Umgekehrt nimmt Nickeloxyhydroxid beim Entladen ein Elektron auf und wandelt sich mit Wasser unter Abgabe eines Hydroxid-Ions in Nickelhydroxid um. Theoretisch ist es somit möglich, dass eine positive Elektrode in vollständig geladenem Zustand ausschließlich Nickeloxyhydroxid aufweist und in vollständig entladenem Zustand ausschließlich Nickelhydroxid. In der Praxis liegen die beiden Verbindungen in Elektroden aber meist nebeneinander vor, wobei das Mengenverhältnis der Verbindungen zueinander vom Ladezustand der Elektroden abhängt.

### Hilfselektrode

In besonders bevorzugten Ausführungsformen weist die Zelle eine mit der negativen Elektrode elektrisch verbundene Hilfselektrode zum Abbau eines gegebenenfalls im Gehäuse der Zelle entstehenden Sauerstoffdrucks auf. Derlei Hilfselektroden sind für andere elektrochemische Systeme bereits bekannt, beispielsweise wird in der EP 0 218 028 A1 eine Hilfselektrode für einen Nickel/Cadmium-Akkumulator beschrieben.

Bei der Hilfselektrode kann es sich beispielsweise um eine Dreischichtelektrode aus einer den Zutritt des Sauerstoffs begünstigenden, hydrophoben und elektrisch nicht leitenden ersten Schicht, einer hydrophilen zweiten Schicht und einer die katalytische Sauerstoffreduktion unterhaltenden, in elektronischem Kontakt zur negativen Hauptelektrode stehenden, hydrophoben dritten Schicht handeln. Eine solche Dreischichtelektrode ist aus der EP 0 416 244 A1 bekannt. Die dritte Schicht besteht demzufolge bevorzugt aus einer aktivkohlehaltigen Walzmischung (z.B. aus 50 Gew.% bis 80 Gew.% Aktivkohle, 3 Gew.% bis 20 Gew.% Leitruß und 10 Gew.% bis 30 Gew.% PTFE). Der ersten und der zweiten Schicht liegt bevorzugt ein einlagiges Kunststofffaservlies zugrunde, auf dessen eine Seite eine wasserhaltige Celluloseäther-Mischung aufgebracht ist. Details hierzu finden sich in der EP 0 416 244 A1.

Besonders bevorzugt kann die Hilfselektrode auch als Einschichtelektrode ausgebildet sein. Zum Abbau eines gegebenenfalls in dem Gehäuse entstehenden Sauerstoffdrucks kann beispielsweise eine Mischung aus Aktivkohle, Ruß und Polytetrafluorethylen (PTFE) auf die negative Elektrode aufgebracht werden, beispielsweise als Schicht in einer Dicke im Bereich von 50 bis 100 µm.

In weiteren bevorzugten Ausführungsformen kann die Hilfselektrode neben den genannten Komponenten wie die negative Elektrode, mit der sie elektrisch verbunden ist, auch einen Anteil an Eisen in metallischer und/oder oxidierter Form oder einen Anteil an dem nicht kohlenstoffbasierten H2-Speichermaterial aufweisen.

Die Hilfselektrode hat in der Zelle einen bifunktionellen Charakter. Zum einen kann sie, wie bereits erwähnt, zum Abbau eines gegebenenfalls in dem Gehäuse entstehenden Sauerstoffdrucks beitragen. Zum anderen ist sie aber vor allem aufgrund des Anteils an Aktivkohle und Ruß wie die negative Elektrode dazu in der Lage, elektrische Ladung zu speichern. Sie erhöht damit anodenseitig die Doppelschichtkapazität.

Es ist bevorzugt, dass die positive Elektrode der Zelle eine geringere absolute Kapazität aufweist als die negative Elektrode. Mit anderen Worten, die Kapazität der negativen Elektrode zur Aufnahme elektrischer Energie überschreitet die diesbezügliche Kapazität der positiven Elektrode. Dies gilt insbesondere, wenn die Zelle die erwähnte Hilfselektrode aufweist. In diesem Fall ist es bevorzugt, dass die addierten absoluten Kapazitäten der negativen Elektrode und der Hilfselektrode die absolute Kapazität der positiven Elektrode überschreiten.

Vorzugsweise übersteigt die Kapazität der negativen Elektrode die der positiven Elektrode mindestens um den Faktor 1,1, bevorzugt um einen Faktor im Bereich von 1,1 bis 2,0. Bei einer Überladung der Zelle ist dadurch gewährleistet, dass es zur Bildung von Sauerstoff und nicht etwa von Wasserstoff kommt.

Gegenüber klassischen Nickel-Eisen Akkumulatoren und Nickel-Metallhydrid-Batterien weisen die hier beschriebenen Neuentwicklungen bereits ohne Vorhandensein der Hilfselektrode eine erhöhte Überladestabilität bei hohen Temperaturen auf. Mit der Hilfselektrode wird dieser Effekt noch verstärkt. Die erhöhte Überladestabilität der Zelle dürfte insbesondere auf das kohlenstoffbasierte Speichermaterial in der negativen Elektrode zurückzuführen sein, das zu einem Verzehr in Folge einer Überladung entstandenen Sauerstoffs beitragen kann.

In Folge der Überladestabilität ist es möglich, das Gehäuse der Zelle gas- und flüssigkeitsdicht auszubilden. Bevorzugt weisen Zellen mit einem solchen Gehäuse auch eine Hilfselektrode auf, wie sie oben beschrieben ist.

Unter einem gasdichten Verschluss soll vorliegend verstanden werden, dass in der Zelle gebildetes Gas im Normalbetrieb nicht aus dem Gehäuse entweichen kann. Das Gehäuse umfasst also kein Mittel zu einer gezielten Entlüftung wie beispielsweise ein Ventil. Allerdings kann aus Sicherheitsgründen eine Berstmembran vorgesehen sein, die bei Überschreiten eines Druckschwellenwerts irreversibel zerstört wird.

### Negative Elektrode

Bevorzugt weist die negative Elektrode der elektrochemischen Zelle das kohlenstoffbasierte Speichermaterial in einem Anteil von mindestens 5 Gew.-% auf.

Besonders bevorzugt enthält die negative Elektrode das kohlenstoffbasierte Speichermaterial in einem Anteil von mehr als 5 Gew.-%. Besonders bevorzugt liegt dieser zwischen 5 Gew.-% und 100 Gew.-%, bevorzugt zwischen 5 Gew.-% und 90 Gew.-%, weiter bevorzugt zwischen 5 Gew.-% und 75 Gew.-%, insbesondere zwischen 5 Gew.-% und 50 Gew.-%. Innerhalb des letztgenannten Bereiches sind Gewichtsanteile zwischen 5 Gew.-% und 25 Gew.-%, insbesondere zwischen 5 Gew.-% und 15 Gew.-%, weiter bevorzugt.

An Stelle der im vorangehenden Absatz genannten Bereichsuntergrenzen kann die Untergrenze für den Anteil an kohlenstoffbasiertem Speichermaterial in den genannten Bereichen auch 5,5 Gew.-%, bevorzugt 6 Gew.-%, insbesondere 6,5 Gew.-%, betragen.

Alle genannten Prozentangaben beziehen sich bevorzugt auf das Gesamtgewicht der negativen Elektrode in trockenem Zustand (also ohne Elektrolyt), abzüglich des Gewichts des Stromableiters, das nicht berücksichtigt wird.

Wie aus obigen Ausführungen hervorgeht, kann in der beschriebenen Zelle eine positive Elektrode auf Basis von Nickelhydroxid / Nickeloxyhydroxid gegen eine Elektrode geschaltet sein, die ausschließlich das kohlenstoffbasierte Speichermaterial, das zur Ausbildung einer elektrischen Doppelschicht befähigt ist, aufweist (Variante 1). Umfasst die negative Elektrode hingegen die Kombination aus dem kohlenstoffbasierten Speichermaterial und dem nicht kohlenstoffbasierten H2-Speichermaterial (Variante 2), so beträgt der Anteil an dem H2-Speichermaterial in der negativen Elektrode vorzugsweise zwischen 25 Gew.-% und 95 Gew.-%, bevorzugt zwischen 50 Gew.-% und 95 Gew.-%, besonders bevorzugt zwischen 75 Gew.-% und 95 Gew.-%, Wenn die negative Elektrode die Kombination aus dem kohlenstoffbasierten Speichermaterial und dem Eisen in metallischer (Oxidationsstufe 0) und/oder oxidierter Form (Oxidationsstufe 2 oder 3) gemäß Variante 3 umfasst, so beträgt der Anteil an dem Eisen in der negativen Elektrode vorzugsweise zwischen 25 Gew.-% und 95 Gew.-%, bevorzugt zwischen 50 Gew.-% und 95 Gew.-%, besonders bevorzugt zwischen 75 Gew.-% und 95 Gew.-%, insbesondere zwischen 85 Gew.-% und 95 Gew.-%.

Alle genannten Prozentangaben beziehen sich auch hier vorzugsweise auf das Gesamtgewicht der negativen Elektrode in trockenem Zustand (also ohne Elektrolyt), abzüglich des Gewichts des Stromableiters.

Als zur Ausbildung einer elektrischen Doppelschicht befähigtes kohlenstoffbasiertes Speichermaterial kommen vorliegend insbesondere Aktivkohle und Graphen infrage. Bei Aktivkohle handelt es sich bekanntlich um einen porösen, feinkörnigen Kohlenstoff mit einer sehr großen inneren Oberfläche. Besonders bevorzugt ist Aktivkohle, die eine BET-Oberfläche von mindestens 900 m²/g (bestimmt gemäß DIN ISO 9277) und einem Kapazitätswert von mindestens 60 F/g aufweist (bestimmt gemäß DIN IEC 62391).

Bei Graphen handelt es sich um eine Kohlenstoffmodifikation mit zweidimensionaler Struktur. Eine Vielzahl von verketteten Benzol-Ringen bildet ein bienenwabenförmiges Muster aus, in dem jedes Kohlenstoffatom im Winkel von 120° von drei weiteren Kohlenstoffatomen umgeben ist und wobei alle Kohlenstoffatome sp²-hybridisiert sind. Graphen bietet die theoretisch größte mit Kohlenstoff erreichbare Oberfläche pro Gewichtseinheit und ist daher aktuell Gegenstand intensiver Untersuchungen im Zusammenhang mit der Entwicklung von Superkondensatoren. Sowohl Graphen als auch Aktivkohle sind darüber hinaus in der Lage, Wasserstoff zu speichern. Unter anderem diese Eigenschaft macht sie als Elektrodenaktivmaterial für die negative Elektrode der Zelle so interessant.

Selbstverständlich können Graphen und Aktivkohle auch in Kombination miteinander verwendet werden. Hierbei ist jedes Mischungsverhältnis denkbar.

Als H2-Speichermaterial kommen bevorzugt aus dem Bereich der Nickel-Metallhydrid-Batterien bekannte Wasserstoffspeicherlegierungen zum Einsatz. Zu erwähnen sind in diesem Zusammenhang insbesondere AB₂-Legierungen und AB5-Legierungen. Weiterhin kommen Raney-Nickel (eine katalytisch aktive Nickel-Aluminium-Legierung) sowie elektrochemisch hochaktives metallisches Nickel (INCO Nickel) in Frage.

AB₂-Legierungen basieren in der Regel auf Titan und Nickel im effektiven Verhältnis 1:2. In der Praxis werden das Titan und das Nickel häufig teilweise durch einen oder mehrere Zusätze, insbesondere aus der Gruppe mit Chrom, Vanadium oder Zirkonium, ersetzt.

Bei AB5-Legierungen handelt es sich meist um Mischungen aus Lanthan und Nickel im effektiven Verhältnis 1:5. In der Praxis werden das Lanthan und das Nickel häufig teilweise durch einen oder mehrere Zusätze, insbesondere aus der Gruppe mit Mangan, Nickel, Kupfer, Chrom, Aluminium, Kobalt, Zink, Zirkonium oder Cer, ersetzt.

Alternativ oder zusätzlich können an Stelle der erwähnten Legierungen oder zusätzlich zu diesen auch A₂B₇- oder AB₃-Legierungen verwendet werden. Auch diese Legierungstypen wurden bereits im Zusammenhang mit Nickel-Metallhydrid-Batterien diskutiert. Beispiele für Legierungen dieser Art sind beispielsweise La_{16,3}Mg_{7,0}Ni_{65,1}Co_{11,6} (A₂B₇) oder La_{0,7}M_{90,3}Ni₃₋ₓFeₓ (AB₃ mit x = 0 - 0,4).

Das verwendete kohlenstoffbasierte Speichermaterial liegt bevorzugt in partikulärer Form, also pulverförmig, vor, Bei der Herstellung der negativen Elektroden (in allen Varianten) kommt es insbesondere in Form eines Pulvers mit einer mittleren Partikelgröße im Bereich von 50 nm bis 500 µm, insbesondere mit einer mittleren Partikelgröße im Bereich von 10 µm bis 50 µm, zum Einsatz.

Das verwendete H2-Speichermaterial und das Eisen (in oxidierter und reduzierter Form) liegen ebenfalls bevorzugt in partikulärer Form vor. Bei der Herstellung der negativen Elektroden gemäß den Varianten 2 und 3 kommen das H2-Speichermaterial und das Eisen insbesondere in Form von Pulvern mit einer mittleren Partikelgröße im Bereich von 10 nm bis 100 µm, insbesondere mit einer mittleren Partikelgröße im Bereich von 10 nm bis 1 µm, zum Einsatz.

### Positive Elektrode

Das Nickelhydroxid und/oder Nickeloxyhydroxid wird bevorzugt in Form von sphärischen Partikeln eingesetzt. Unabhängig davon kann es bevorzugt sein, dass die eingesetzten Partikel aus Nickelhydroxid und/oder Nickeloxyhydroxid eine Oberfläche aufweisen, die zumindest teilweise mit Kobalt beschichtet ist.

In aller Regel enthält die positive Elektrode das Nickelhydroxid und/oder das Nickeloxyhydroxid in einem Anteil zwischen 10 Gew.-% und 100 Gew.-%, bevorzugt zwischen 25 Gew.-% und 100 Gew.-%, insbesondere zwischen 50 Gew.-% und 100 Gew.-%. Diese Prozentangaben beziehen sich bevorzugt auf das Gesamtgewicht der positiven Elektrode in trockenem Zustand (also ohne Elektrolyt), abzüglich des Gewichts des enthaltenen Stromableiters.

### Bevorzugte Ausführungsformen der Elektroden

Zur Herstellung besonders bevorzugter Ausführungsformen der negativen Elektrode gemäß den Varianten 2 und 3 werden das pulverförmige kohlenstoffbasierte Speichermaterial und das pulverförmige Eisen oder das das pulverförmige kohlenstoffbasierte Speichermaterial und das pulverförmige H2-Speichermaterial zu einer Mischung verarbeitet und, beispielsweise als Paste, in einem weiteren Schritt zu der Elektrode verarbeitet. Diesen Mischungen werden häufig noch eine oder mehrere weitere zusätzliche Komponenten zugesetzt. Entsprechend können die negative und die positive Elektrode neben den genannten Komponenten gegebenenfalls noch eine oder mehrere zusätzliche Komponenten aufweisen. Auf diese zusätzlichen Komponenten wird im Folgenden noch detailliert eingegangen.

Für die negative Elektrode kommen insbesondere die folgenden zusätzlichen Komponenten in den folgenden Anteilen in Frage:
- 0,1 Gew.-% bis 10 Gew.-%, bevorzugt 1 Gew.-% bis 5 Gew.-%, eines Elektrodenbinders
- 0,1 Gew.-% bis 10 Gew.-%, bevorzugt 1 Gew.-% bis 5 Gew.-%, eines Leitmittels

Diese zusätzlichen Komponenten können der negativen Elektrode einzeln oder in Kombination zugesetzt sein.

Beim Vorliegen einer Kombination aus dem kohlenstoffbasierten Speichermaterial und dem nicht kohlenstoffbasierten H2-Speichermaterial (Variante 2) umfasst die negative Elektrode in einer Weiterbildung besonders bevorzugt die folgenden Komponenten in den folgenden Anteilen:
- zwischen 75 Gew.-% und 94,9 Gew.-%, insbesondere zwischen 85 Gew.-% und 94,9 Gew.-%, des H2-Speichermaterials
- zwischen 5 Gew.-% und 19,9 Gew.-%, insbesondere zwischen 5 Gew.-% und 14,9 Gew.-%, des kohlenstoffbasierten Speichermaterials
- zwischen 0,1 Gew.-% und 10 Gew.-%, bevorzugt zwischen 0,1 Gew.-% und 5 Gew.-%, des Elektrodenbinders

Wenn die negative Elektrode weder einen Anteil an dem H2-Speichermaterial noch einen Anteil an dem Eisen enthält (Variante 1), so umfasst sie besonders bevorzugt die folgenden Komponenten in den folgenden Anteilen:
- zwischen 90 Gew.-% und 99,9 Gew.-%, insbesondere zwischen 95 Gew.-% und 99,9 Gew.-%, des kohlenstoffbasierten Speichermaterials
- zwischen 0,1 Gew.-% und 10 Gew.-%, bevorzugt zwischen 0,1 Gew.-% und 5 Gew.-%, des Elektrodenbinders

Beim Vorliegen einer Kombination aus dem kohlenstoffbasierten Speichermaterial und dem Eisen (Variante 3) umfasst die negative Elektrode in ersten Weiterbildung besonders bevorzugt die folgenden Komponenten in den folgenden Anteilen
- zwischen 75 Gew.-% und 94,9 Gew.-%, insbesondere zwischen 85 Gew.-% und 94,9 Gew.-%, des Eisens
- zwischen 5 Gew.-% und 19,9 Gew.-%, insbesondere zwischen 5 Gew.-% und 14,9 Gew.-%, des kohlenstoffbasierten Speichermaterials
- zwischen 0,1 Gew.-% und 10 Gew.-%, bevorzugt zwischen 0,1 Gew.-% und 5 Gew.-%, des Elektrodenbinders

Für die positive Elektrode kommen insbesondere die folgenden zusätzlichen Komponenten in den folgenden Anteilen in Frage:
- 0,1 Gew.-% bis 10 Gew.-%, bevorzugt 1 Gew.-% bis 5 Gew.-%, eines Elektrodenbinders
- 0,1 Gew.-% bis 90 Gew.-%, bevorzugt 0,1 Gew.-% bis 50 Gew.-%, besonders bevorzugt 0,1 Gew.-% bis 40 Gew.-%, insbesondere 0,1 Gew.-% bis 20 Gew.-%, eines Leitmittels
- ein kohlenstoffbasiertes Speichermaterial, das die Speicherung von elektrischer Ladung in der Elektrode durch Ausbildung einer elektrischen Doppelschicht (Helmholtz-Doppelschicht) ermöglicht, insbesondere in einem Anteil von 0,1 Gew.-% bis 20 Gew.-%

Diese Komponenten können der positiven Elektrode einzeln oder in Kombination zugesetzt sein.

In einer Weiterbildung umfasst die positive Elektrode besonders bevorzugt die folgenden Komponenten in den folgenden Anteilen:
- zwischen 50 Gew.-% und 99,8 Gew.-% Nickelhydroxid und/oder Nickeloxyhydroxid
- zwischen 0,1 Gew.-% und 40 Gew.-%, bevorzugt zwischen 0,1 Gew.-% und 45 Gew.-%, des Leitmittels
- zwischen 0,1 Gew.-% und 10 Gew.-%, bevorzugt zwischen 0,1 Gew.-% und 5 Gew.-%, des Elektrodenbinders

Bevorzugt gilt auch für all diese bevorzugten Ausführungsformen, dass sich diese Prozentangaben jeweils auf das Gesamtgewicht der positiven Elektrode und der negativen Elektrode in trockenem Zustand (also ohne Elektrolyt) beziehen, abzüglich des Gewichts des jeweiligen Stromableiters.

Weiterhin ist bevorzugt, dass sich in allen angegebenen sowie in allen aus obigen Angaben ableitbaren Zusammensetzungen für die positive und die negative Elektrode die Prozentanteile der jeweils enthaltenen Komponenten auf 100 Gew.-% addieren.

Bei dem Leitmittel handelt es sich bevorzugt um ein Metallpulver, insbesondere um Nickel- und/oder Kobaltpulver. Alternativ oder zusätzlich können auch kohlenstoffbasierte Leitmittel wie Ruß, Graphit, Kohlenstoffnanoröhrchen (CNTs), Nanokohlenstoffe oder im Fall der positiven Elektrode auch Graphen verwendet werden.

Als Elektrodenbinder wird bevorzugt ein zellulosebasierter Binder, beispielsweise Carboxymethylzellulose oder ein Derivat von Carboxymethylzellulose, verwendet. Besonders geeignet sind auch wasserlösliche Zelluloseether wie beispielsweise Methylhydroxyethylzellulose (MHEC), Methylhydroxypropylzellulose (MHPC) und Hydroxyethylzellulose (HEC). Alternativ kommen aber auch Polyacrylate oder kunststoffbasierte Binder wie zum Beispiel PTFE-Binder (PTFE = Polytetrafluorethylen) oder Binder auf Basis von SBR (Styrene-Butadiene-Rubber) in Frage.

Die Elektroden der Zelle müssen nicht zwingend einen Elektrodenbinder enthalten. Sie können beispielsweise auch binderfrei als Sinterelektroden oder als Presslinge gefertigt werden.

Für das kohlenstoffbasierte Speichermaterial, das in bevorzugten Ausführungsformen in der positiven Elektrode enthalten sein kann, kommen die gleichen Materialien in Frage wie im Fall der negativen Elektrode. Dabei handelt es sich vor allem um Aktivkohle mit den oben genannten Eigenschaften und um Graphen.

Neben den genannten Zusätzen können die positive und/oder die negative Elektrode noch weitere Zusätze enthalten. Beispielhaft zu nennen sind in diesem Zusammenhang insbesondere Kobaltoxid, Kobalthydroxid, Eisensulfid, Kaliumsulfid, Zinksulfat, Ammoniumcarbonat oder Calziumhydroxid.

### Stromableiter

In bevorzugten Ausführungsformen bildet der Stromableiter der positiven und/oder der negativen Elektrode eine dreidimensionale Leitmatrix, in die anodenseitig das jeweilige Speichermaterial und kathodenseitig das Nickelhydroxid und/oder das Nickeloxyhydroxid eingebettet ist.

In bevorzugten Ausführungsformen kommen auf Seite der positiven und/oder der negativen Elektrode als Stromableiter metallische oder metallbeschichtete offenporige Schäume oder Ableiter aus einem metallischen oder metallbeschichteten Vlies zum Einsatz. Derartige Ableiter kommen klassisch vor allem auf der Seite der positiven Elektrode von Nickel-Cadmium- oder Nickel-Metallhydrid-Akkumulatoren in Knopfzellenform zum Einsatz. Beispielhaft wird in diesem Zusammenhang auf die EP 0 658 949 A1 verwiesen. Sowohl die erwähnten Schäume als auch die erwähnten Vliese sind kommerziell erhältlich. Bevorzugt bestehen sie aus Nickel oder Kupfer oder sind mit einem dieser Metalle beschichtet.

In einigen Ausführungsformen kann es bevorzugt sein, dass lediglich auf Seite der negativen Elektrode ein dreidimensionaler Ableiter aus dem erwähnten Schaum oder Vlies verwendet wird, während auf Seite der positiven Elektrode ein flacher, zweidimensionaler Ableiter, beispielsweise eine Metallfolie oder ein Metallnetz, zum Einsatz kommt. In diesem Fall werden die positiven Elektroden meist über ein Sinterverfahren hergestellt.

Natürlich kann es auch bevorzugt sein, auf Seite der positiven und/oder der negativen Elektrode an Stelle der dreidimensionalen Ableiter einen flachen, zweidimensionalen Ableiter, beispielsweise eine Metallfolie, einzusetzen.

Beim Vorliegen einer Kombination aus dem kohlenstoffbasierten Speichermaterial und dem nicht kohlenstoffbasierten H2-Speichermaterial (Variante 2) oder dem Eisen (Variante 3) liegen die Partikel aus dem kohlenstoffbasierten Speichermaterial und aus dem Eisen oder aus dem H2-Speichermaterial in der negativen Elektrode, in bevorzugten Ausführungsformen in der erwähnten dreidimensionalen Leitmatrix aus dem Stromableiter, bevorzugt in einer homogenen Verteilung vor. Zurückzuführen ist dies vor allem auf das erwähnte Mischen der jeweiligen Komponenten der negativen Elektrode. Zur Realisierung einer derartigen Anordnung können das H2-Speichermaterial oder das Eisen und das kohlenstoffbasierte Speichermaterial zu einer Mischung, insbesondere einer Paste verarbeitet werden, gegebenenfalls unter Hinzufügung mindestens einer der oben beschriebenen zusätzlichen Komponenten. Durch intensives Mischen der Komponenten wird gewährleistet, dass alle Komponenten der Mischung in gleichmäßiger, homogener Verteilung vorliegen. Anschließend wird die Mischung, insbesondere die Paste, in die erwähnte dreidimensionale Matrix aus einem Stromableiter eingebracht oder in Form einer dünnen Schicht auf einen zweidimensionalen Stromableiter aufgebracht.

In einigen Ausführungsformen kann es allerdings auch bevorzugt sein, dass die negative Elektrode einen ersten Teilbereich, insbesondere eine erste Schicht aufweist, in der das kohlenstoffbasierte Speichermaterial angereichert ist und entsprechend einen zweiten Teilbereich, insbesondere eine zweite Schicht, in der das nicht kohlenstoffbasierte H2-Speichermaterial oder das Eisen angereichert ist. Zur Realisierung einer derartigen Anordnung werden das H2-Speichermaterial oder das Eisen und das kohlenstoffbasierte Speichermaterial in der Regel nicht in einem Schritt verarbeitet. So ist es beispielsweise möglich,
- in einem ersten Schritt das H2-Speichermaterial oder das Eisen in die erwähnte dreidimensionale Matrix aus einem Stromableiter einzubringen und anschließend den Stromableiter auf seiner Außenseite mit dem kohlenstoffbasierten Speichermaterial zu beschichten
   oder
- in einem ersten Schritt in einen bandförmigen Ableiter aus einem Nickelschaum das H2-Speichermaterial oder das Eisen einzubringen und anschließend auf einer oder sogar auf beiden Seiten des Bandes eine Schicht aus dem kohlenstoffbasierten Speichermaterial anzuordnen.

Bevorzugt kann die negative Elektrode der elektrochemischen Zelle also eine Mehrschichtstruktur, insbesondere eine Zweischichtstruktur, aufweisen. Dabei bilden z.B. der Stromableiter und das Eisen gemeinsam die erwähnte zweite Schicht, wohingegen das kohlenstoffbasierte Speichermaterial die erwähnte erste Schicht bildet.

### Separator / Elektroden-Separator-Verbund

Sowohl der Separator als auch die positive und die negative Elektrode sind bevorzugt in Form von dünnen Schichten ausgebildet. Sie können beispielsweise in Form von Bändern oder flachen Streifen bereitgestellt werden. Im Falle der Elektroden sind Schichten mit einer Dicke im Bereich von 50 µm bis 500 µm bevorzugt. Die Dicke des verwendeten Separators liegt bevorzugt im Bereich von 10 µm bis 100 µm.

Bei dem Separator der elektrochemischen Zelle handelt es sich bevorzugt um eine poröse Kunststofffolie, insbesondere um eine Folie aus einem Polyolefin, aus PEEK (Polyetheretherketon) oder aus PES (Polyethersulfon). Es können ohne weiteres aber auch Separatoren aus Papier oder aus einem Vlies eingesetzt werden. Im Grunde ist lediglich erforderlich, dass der Separator eine ausreichende Porosität aufweist, um von dem Elektrolyten durchdrungen zu werden und dass er gegenüber diesem stabil ist.

Die elektrochemische Zelle liegt bevorzugt als Verbund mit der Schichtsequenz positive Elektrode / Separator / negative Elektrode vor. Besonders bevorzugt kann die elektrochemische Zelle in Form einer Bizelle vorliegen, also mit der Schichtsequenz positive Elektrode / Separator / negative Elektrode / Separator / positive Elektrode oder negative Elektrode / Separator / positive Elektrode / Separator / negative Elektrode.

Wenn die negative Elektrode, wie oben ausgeführt, eine erste Schicht aufweist, in der das kohlenstoffbasierte Speichermaterial angereichert ist, so ist es bevorzugt, dass diese Schicht zwischen der negativen Elektrode und einem benachbarten Separator angeordnet ist.

Die Elektroden der elektrochemischen Zelle werden bevorzugt kalandriert, bevor sie miteinander sowie mit dem Separator kombiniert werden.

Der Verbund mit der Schichtsequenz positive Elektrode / Separator / negative Elektrode liegt in einigen bevorzugten Ausführungsformen in Form eines spiralförmigen Wickels vor. Zu Herstellung eines solchen spiralförmigen Wickels können beispielsweise eine bandförmige positive Elektrode und eine bandförmige negative Elektrode mit zwei Separatorbändern mittels eines Laminations- oder Klebevorgangs zu einem Verbund der Sequenz Separator / negative Elektrode / Separator / positive Elektrode kombiniert und anschließend aufgewickelt werden.

### Zellverbund / bipolare Anordnung

Aus mehreren der beschriebenen Zellen kann ein Zellverbund gebildet werden. Innerhalb des Verbundes können die Zellen parallel zueinander oder in Reihe geschaltet sein. Bei der Balancierung eines solchen Zellverbunds kann sich die erwähnte hohe Überladestabilität als besonders vorteilhaft erweisen. Um alle Zellen des Verbundes wieder auf ein identisches Spannungsniveau zu bringen, kann der Zellverbund gezielt überladen werden. Dies ist in aller Regel nicht möglich, ohne zumindest einzelne Zellen des Verbundes irreparabel zu schädigen. Aufgrund des kohlenstoffbasierten Speichermaterials in den negativen Elektroden der Zellen, das zum Verzehr von bei der Überladung erzeugtem Sauerstoff beitragen kann, ist vorliegend die Gefahr einer solchen Schädigung jedoch minimiert. Dies gilt insbesondere dann, wenn eines oder mehrere der Zellen, bevorzugt alle Zellen des Verbundes, die erwähnte Hilfselektrode aufweisen.

Natürlich ist es auch möglich, mehrere elektrochemische Zellen aus positiver und negativer Elektrode sowie aus einem oder mehreren Separatoren übereinander zu stapeln. Ein möglicher Aufbau eines entsprechenden Stapels ist beispielsweise in der EP 1 011 163 A1 dargestellt.

In bevorzugten Ausführungsformen sind zwei oder mehr Zellen in einer bipolaren Anordnung miteinander kombiniert. Eine bipolare Anordnung elektrochemischer Zellen zeichnet sich dadurch aus, dass einzelne elektrochemische Zellen als Subzellen fungieren und durch leitende Zwischenwände in Reihe verschaltet sind. Jede Subzelle besitzt dabei eine positive und eine negative Elektrode, die durch einen elektrolytgetränkten Separator voneinander getrennt sind. Zwischen benachbarten Subzellen befindet sich eine Verbindungswand. Diese stellt eine elektrische Verbindung zwischen der positiven Elektrode der einen Zelle und der negativen Elektrode der anderen Zelle her. Gleichzeitig separiert sie die Elektrolyträume der Subzellen voneinander.

### Gehäuse

Das Gehäuse der Zelle kann beispielsweise als Knopfzellengehäuse ausgebildet sein, beispielsweise als Gehäuse, wie es in der bereits erwähnten EP 1 011 163 A1 dargestellt ist. Alternativ kann die Zelle aber auch Flachzelle ausgebildet sein, wie sie beispielsweise in der EP 1 391 947 A1 beschrieben ist. In diesem Fall wird ihr Gehäuse aus dünnen Metallfolien gebildet, die über eine Siegelschicht miteinander verbunden sind.

Insbesondere, wenn der oben beschriebene Verbund mit der Schichtsequenz positive Elektrode / Separator / negative Elektrode in Form eines spiralförmigen Wickels vorliegt, kann das Gehäuse auch als zylindrisches Rundzellengehäuse ausgebildet sein.

Besonders bevorzugt handelt es sich bei dem Gehäuse der Zelle um ein metallisches Gehäuse, beispielsweise um ein Gehäuse aus Edelstahl oder aus einem vernickelten Stahl oder Edelstahl.

### Elektrolyt

Der wässrige Elektrolyt der elektrochemischen Zelle weist bevorzugt im Bereich von 0,1 M bis 10 M mindestens einer gelöst vorliegenden Hydroxidverbindung auf. Besonders bevorzugt enthält der Elektrolyt als Hydroxidverbindung mindestens ein Metallhydroxid, insbesondere Natrium-, Lithium- oder Kaliumhydroxid.

Besonders bevorzugt enthält der Elektrolyt zusätzlich zu der Hydroxidverbindung mindestens eine Sulfatverbindung, insbesondere ein Alkali- oder Erdalkalisulfat. Bevorzugt ist die mindestens eine Sulfatverbindung in einer Konzentration im Bereich von 0,001 Gew.-% bis 0,1 Gew.-% in dem Elektrolyten enthalten.

In bevorzugten Ausführungsformen enthält der Elektrolyt ein sekundäres Leitsalz mit PO₄³⁻, NO₃⁻ oder Cl⁻ Anionen und metallischen Gegenionen.

Dem Elektrolyten können weiterhin auch Additive zugegeben werden wie beispielsweise Verdicker, Korrosionsinhibitoren, Netzmittel und Frostschutzmittel.

### Ausführungsbeispiele

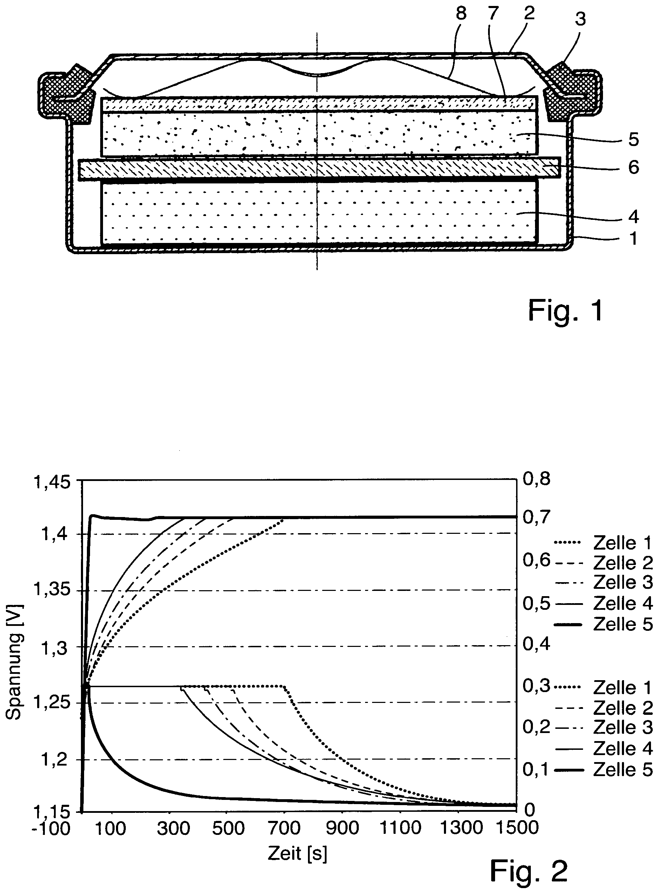

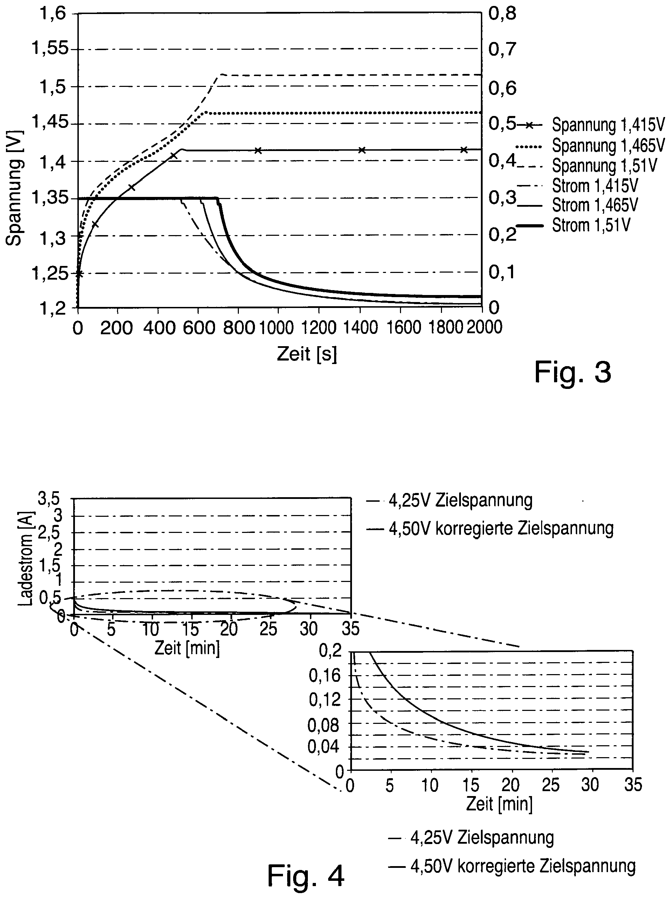

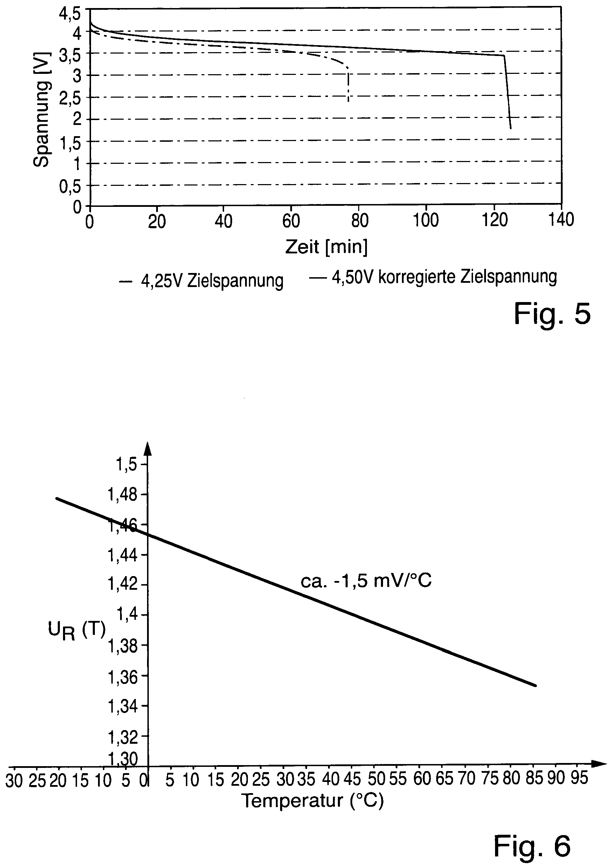

(1) Herstellung einer elektrochemischen Zelle gemäß Variante 2
   Zur Bildung positiver Elektroden wurde eine wässrige Aktivmaterial-Paste auf einen offenporigen Nickelschaum aufgebracht. Der Feststoffanteil der Paste setzte sich aus den folgenden Komponenten zusammen:
      - 90 Gew.-% Ni(OH)₂,
      - 4 Gew.-% Kobalt-Pulver als Leitmittel
      - 4 Gew.-% Ruß als weiteres Leitmittel
      - 2 Gew.-% eines wasserlöslichen Zelluloseethers als Binder
   Zur Bildung negativer Elektroden wurde eine wässrige Aktivmaterial-Paste auf einen offenporigen Nickelschaum aufgebracht. Der Feststoffanteil der Paste setzte sich aus den folgenden Komponenten zusammen:
      - 7,5 Gew.-% Aktivkohle mit einer BET-Oberfläche > 900 m²/g
      - 90 Gew.-% einer A₂B₇-Legierung
      - 2,5 Gew.-% eines wasserlöslichen Zelluloseethers als Binder
   Die Elektroden wurden jeweils getrocknet und einem Walzvorgang unterworfen. Danach wiesen sie eine Dicke von ca. 250 µm auf.
   Auf eine Seite der negativen Elektrode wurde anschließend als Hilfselektrode zum Abbau eines gegebenenfalls in dem Gehäuse entstehenden Sauerstoffdrucks eine Mischung aus Aktivkohle, Ruß und Polytetrafluorethylen (PTFE) in einer Dicke im Bereich von 50 µm bis 100 µm aufgewalzt. Die exakte Zusammensetzung lag bei 75 Gew.% Aktivkohle, ca. 7,5 Gew.% Leitruß und ca. 17,5 Gew.% PTFE.
   Anschließend wurden die Elektroden mit einem Separator aus Polypropylen (non-woven, Dicke 80 µm) zu einem Elektroden-Separator-Verbund mit der folgenden Schichtsequenz kombiniert:
      Hilfselektrode / negative Elektrode / Separator / positive Elektrode
   Der Verbund wurde mit einem wässrigen Elektrolyten getränkt (6M KOH-Lösung) und in einem Gehäuse aus vernickeltem Edelstahl verbaut, wie es in Fig. 1 dargestellt ist.
   Gemäß Fig. 1 ist der Verbund aus der positiven Elektrode 4, dem Separator 6 und der negativen Elektrode 5 in einem Gehäuse aus den Gehäuseteilen 1 und 2 angeordnet. Das Gehäuse ist mittels der Dichtung 3 flüssigkeits- und gasdicht verschlossen. Auf die dem Separator abgewandte Seite der negativen Elektrode ist die Hilfselektrode 7 aufgewalzt. Mittels der Feder 8 sollen volumetrische Änderungen des Verbundes in Folge von Lade- und Entladevorgängen ausgeglichen werden.
   Die so hergestellte Zelle wies ein Spannungsfenster von 0,8 - 1,5 V auf. Bei Raumtemperatur beträgt die Zielspannung ZU (vor Korrektur) 1,45 V.
   Der Einfluss der Zellalterung auf das Ladeverhalten wurde untersucht. Hierzu wurde der Innenwiderstand (DC) unterschiedlich gealterter Zellen bestimmt. Anschließend wurden fünf Zellen einer CV-Ladung auf 1,415 V unterzogen (Start mit SOC 0%):
      - Zelle 1: Innenwiderstand 43 mOhm
      - Zelle 2: Innenwiderstand 65,9 mOhm
      - Zelle 3: Innenwiderstand 83,8 mOhm
      - Zelle 4: Innenwiderstand 97,4 mOhm
      - Zelle 5: Innenwiderstand 224,4 mOhm
   Je höher der Innenwiderstand der Zellen war, umso weniger Ladung wurde in die Zellen eingeladen und umso stärker fällt der Spannungsabfall aus (s. Fig. 2).
   Mit Zelle 2 wurde untersucht, wie sich eine Korrektur der Ladespannung via K1 auf den Ladevorgang auswirkt. Zelle 2 wurde hierzu bei unterschiedlichen Spannungen (1) 1,415 V, (2) 1,465 V und (3) 1,51 V geladen (jeweils CC-CV-Ladung). Es wurde jeweils der Spannungsabfall beobachtet. Es ist offensichtlich, dass sich die eingeladene Ladungsmenge in Folge der Spannungskorrektur erhöhte (s. Fig. 3).
   Zur Untersuchung der Temperaturabhängigkeit des Ladevorgangs wurde ein Zellmodul einer CV-Ladung auf Uz und U_{ZK} bei - 20 °C unterzogen. Durch Einstellen einer erhöhten Zielspannung via K1 fließt ein höherer Ladestrom. Dies hat eine erhöhte eingeladene Ladungsmenge zur Folge (s. Fig. 4). Offensichtlich wird dies auch anhand von Fig. 5. Hier wird deutlich, dass das gemäß Fig. 4 auf U_{ZK} geladene Zellmodul mehr Ladung aufgenommen hat. Eine Korrektur der Ladespannung kann anhand der Vorgaben von Fig. 6 erfolgen.
(2) Herstellung einer elektrochemischen Zelle gemäß Variante 1
   Zur Bildung positiver Elektroden wurde eine wässrige Aktivmaterial-Paste auf einen offenporigen Nickelschaum aufgebracht. Der Feststoffanteil der Paste setzte sich aus den folgenden Komponenten zusammen:
      - 50 Gew.-% Ni(OH)₂,
      - 8 Gew.-% Ruß als Leitmittel
      - 40 Gew.-% Graphit als weiteres Leitmittel
      - 2 Gew.-% eines wasserlöslichen Zelluloseethers als Binder
   Zur Bildung negativer Elektroden wurde eine wässrige Aktivmaterial-Paste auf einen offenporigen Nickelschaum aufgebracht. Der Feststoffanteil der Paste setzte sich aus den folgenden Komponenten zusammen:
      - 97,5 Gew.-% Aktivkohle mit einer BET-Oberfläche > 900 m²/g
      - 2,5 Gew.-% eines wasserlöslichen Zelluloseethers als Binder
   Auf eine Seite der negativen Elektrode wurde anschließend als Hilfselektrode zum Abbau eines gegebenenfalls in dem Gehäuse entstehenden Sauerstoffdrucks eine Mischung aus Aktivkohle, Ruß und Polytetrafluorethylen (PTFE) in einer Dicke im Bereich von 50 µm bis 100 µm aufgewalzt. Die exakte Zusammensetzung lag bei 75 Gew.% Aktivkohle, ca. 7,5 Gew.% Leitruß und ca. 17,5 Gew.% PTFE.
   Anschließend wurden die Elektroden mit einem Separator aus Polypropylen (non-woven, Dicke 80 µm) zu einem Elektroden-Separator-Verbund mit der folgenden Schichtsequenz kombiniert:
      Hilfselektrode / negative Elektrode / Separator / positive Elektrode
   Der Verbund wurde mit einem wässrigen Elektrolyten getränkt (6M KOH-Lösung) und in einem Gehäuse aus vernickeltem Edelstahl verbaut, wie es in Fig. 1 dargestellt ist.
   Die so hergestellte Zelle wies ein Spannungsfenster von 0 - 1,6 V auf. Bei Raumtemperatur beträgt die Zielspannung ZU (vor Korrektur) 1,5 V.
(3) Herstellung einer weiteren elektrochemischen Zelle gemäß Variante 2
   Zur Bildung positiver Elektroden wurde eine wässrige Aktivmaterial-Paste auf einen offenporigen Nickelschaum aufgebracht. Der Feststoffanteil der Paste setzte sich aus den folgenden Komponenten zusammen:
      - 60 Gew.-% Ni(OH)₂,
      - 8 Gew.-% Ruß als Leitmittel
      - 30 Gew.-% Graphit als weiteres Leitmittel
      - 2 Gew.-% eines wasserlöslichen Zelluloseethers als Binder
   Zur Bildung negativer Elektroden wurde eine wässrige Aktivmaterial-Paste auf einen offenporigen Nickelschaum aufgebracht. Der Feststoffanteil der Paste setzte sich aus den folgenden Komponenten zusammen:
      - 87,5 Gew.-% Aktivkohle mit einer BET-Oberfläche > 900 m²/g
      - 10 Gew.-% einer A₂B₇-Legierung
      - 2,5 Gew.-% eines wasserlöslichen Zelluloseethers als Binder
   Auf eine Seite der negativen Elektrode wurde anschließend als Hilfselektrode zum Abbau eines gegebenenfalls in dem Gehäuse entstehenden Sauerstoffdrucks eine Mischung aus Aktivkohle, Ruß und Polytetrafluorethylen (PTFE) in einer Dicke im Bereich von 50 µm bis 100 µm aufgewalzt. Die exakte Zusammensetzung lag bei 75 Gew.% Aktivkohle, ca. 7,5 Gew.% Leitruß und ca. 17,5 Gew.% PTFE.
   Anschließend wurden die Elektroden mit einem Separator aus Polypropylen (non-woven, Dicke 80 µm) zu einem Elektroden-Separator-Verbund mit der folgenden Schichtsequenz kombiniert:
      Hilfselektrode / negative Elektrode / Separator / positive Elektrode
   Der Verbund wurde mit einem wässrigen Elektrolyten getränkt (6M KOH-Lösung) und in einem Gehäuse aus vernickeltem Edelstahl verbaut, wie es in Fig. 1 dargestellt ist.
   Die so hergestellte Zelle wies ein Spannungsfenster von 0,6 - 1,5 V auf. Bei Raumtemperatur beträgt die Zielspannung ZU (vor Korrektur) 1,45 V.
(4) Herstellung einer elektrochemischen Zelle gemäß Variante 3
   Zur Bildung positiver Elektroden wurde eine wässrige Aktivmaterial-Paste auf einen offenporigen Nickelschaum aufgebracht. Der Feststoffanteil der Paste setzte sich aus den folgenden Komponenten zusammen:
      - 80 Gew.-% Ni(OH)₂,
      - 4 Gew.-% Kobalt-Pulver als Leitmittel
      - 14 Gew.-% Nickel-Pulver als weiteres Leitmittel
      - 2 Gew.-% eines wasserlöslichen Zelluloseethers als Binder
   Zur Bildung negativer Elektroden wurde eine wässrige Aktivmaterial-Paste auf einen offenporigen Nickelschaum aufgebracht. Der Feststoffanteil der Paste setzte sich aus den folgenden Komponenten zusammen:
      - 20 Gew.-% Aktivkohle mit einer BET-Oberfläche > 900 m²/g
      - 74,5 Gew.-% Eisenpartikel (zumindest teilweise zu Fe(OH)₂ oxidiert) mit einer mittleren Teilchengröße im Bereich von 100 nm bis 200 nm sowie
      - 5 Gew.-% SBR als Binder
      - 0.5 Gew.-% eines weitere wasserlöslichen CMC-Binders/-Verdickers
   Auf eine Seite der negativen Elektrode wurde anschließend als Hilfselektrode zum Abbau eines gegebenenfalls in dem Gehäuse entstehenden Sauerstoffdrucks eine Mischung aus Aktivkohle, Ruß und Polytetrafluorethylen (PTFE) in einer Dicke im Bereich von 50 µm bis 100 µm aufgewalzt. Die exakte Zusammensetzung lag bei 75 Gew.% Aktivkohle, ca. 7,5 Gew.% Leitruß und ca. 17,5 Gew.% PTFE.
   Anschließend wurden die Elektroden mit einem Separator aus Polypropylen (non-woven, Dicke 80 µm) zu einem Elektroden-Separator-Verbund mit der folgenden Schichtsequenz kombiniert:
      Hilfselektrode / negative Elektrode / Separator / positive Elektrode
   Der Verbund wurde mit einem wässrigen Elektrolyten getränkt (6M KOH-Lösung) und in einem Gehäuse aus vernickeltem Edelstahl verbaut, wie es in Fig. 1 dargestellt ist.
   Die so hergestellte Zelle wies ein Spannungsfenster von 0,6 - 1,5 V auf. Bei Raumtemperatur beträgt die Zielspannung ZU (vor Korrektur) 1,45 V.
(5) Herstellung einer weiteren elektrochemischen Zelle gemäß Variante 3
   Zur Bildung positiver Elektroden wurde eine wässrige Aktivmaterial-Paste auf einen offenporigen Nickelschaum aufgebracht. Der Feststoffanteil der Paste setzte sich aus den folgenden Komponenten zusammen:
      - 60 Gew.-% Ni(OH)₂,
      - 32 Gew.-% Aktivkohle
      - 3 Gew.-% Ruß als Leitmittel
      - 3 Gew.-% Ca(OH)2 als Additiv
      - 2 Gew.-% eines wasserlöslichen Zelluloseethers als Binder
   Zur Bildung negativer Elektroden wurde eine wässrige Aktivmaterial-Paste auf einen offenporigen Nickelschaum aufgebracht. Der Feststoffanteil der Paste setzte sich aus den folgenden Komponenten zusammen:
      - 87,0 Gew.-% Aktivkohle mit einer BET-Oberfläche > 900 m²/g
      - 10 Gew.-% Eisenpartikel (zumindest teilweise zu Fe(OH)₂ oxidiert) mit einer mittleren Teilchengröße im Bereich von 100 bis 200 nm
      - 2,5 Gew.-% eines wasserlöslichen SBR-Binders
      - 0.5 Gew.-% eines weitere wasserlöslichen CMC-Binders/-Verdickers
   Auf eine Seite der negativen Elektrode wurde anschließend als Hilfselektrode zum Abbau eines gegebenenfalls in dem Gehäuse entstehenden Sauerstoffdrucks eine Mischung aus Aktivkohle, Ruß und Polytetrafluorethylen (PTFE) in einer Dicke im Bereich von 50 µm bis 100 µm aufgewalzt. Die exakte Zusammensetzung lag bei 75 Gew.% Aktivkohle, ca. 7,5 Gew.% Leitruß und ca. 17,5 Gew.% PTFE.
   Anschließend wurden die Elektroden mit einem Separator aus Polypropylen (non-woven, Dicke 80 µm) zu einem Elektroden-Separator-Verbund mit der folgenden Schichtsequenz kombiniert:
      Hilfselektrode / negative Elektrode / Separator / positive Elektrode
   Der Verbund wurde mit einem wässrigen Elektrolyten getränkt (6M KOH-Lösung) und in einem Gehäuse aus vernickeltem Edelstahl verbaut, wie es in Fig. 1 dargestellt ist.
   Die so hergestellte Zelle wies ein Spannungsfenster von 0,6 - 1,5 V auf. Bei Raumtemperatur beträgt die Zielspannung ZU (vor Korrektur) 1,45 V.

## Patentansprüche

1. Verfahren zum Betrieb eines wiederaufladbaren Speichersystems für elektrische Energie, das mindestens eine sekundäre elektrochemische Zelle umfasst, **dadurch gekennzeichnet, dass** zum Laden des Speichersystems
• eine Zielspannung Uz festgelegt wird,
• ein Korrekturfaktor K1 für die Zielspannung Uz bestimmt wird, der vom Alterungszustand (SOH) der mindestens einen elektrochemischen Zelle abhängt,
• ein Korrekturfaktor K2 für die Zielspannung Uz bestimmt wird, der von der Umgebungstemperatur und/oder der Temperatur des Speichersystems oder einer Komponente des Speichersystems abhängt,
• die bestimmten Korrekturfaktoren K1 und/oder K2 auf die Zielspannung Uz zwecks Ermittlung einer korrigierten Zielspannung U_{ZK} angewendet werden und
• das Speichersystem bei einem Ladestrom und einer Ladespannung geladen wird, bis die Zielspannung U_{ZK} an dem Speichersystem erreicht wird,
wobei die sekundäre elektrochemische Zelle eine negative Elektrode, eine positive Elektrode, einen porösen Separator, der die negative und die positive Elektrode voneinander trennt, einen wässrigen alkalischen Elektrolyten, mit dem die Elektroden und der Separator getränkt sind und ein Gehäuse, das die Elektroden, den Separator und den Elektrolyten umschließt, aufweist, und die negative Elektrode der elektrochemischen Zelle einen Stromableiter sowie Aktivkohle und/oder Graphen als kohlenstoffbasiertes Speichermaterial, das die Speicherung von elektrischer Ladung in der Elektrode durch Ausbildung einer elektrischen Doppelschicht ermöglicht, umfasst, wobei das kohlenstoffbasierte Speichermaterial in der negativen Elektrode, bezogen auf das Gesamtgewicht der Elektrode in trockenem Zustand ohne Berücksichtigung des Stromableiters, in einem Anteil zwischen 5 Gew.-% und 100 Gew.-% enthalten ist.

2. Verfahren nach Anspruch 1, **dadurch gekennzeichnet, dass** zur Bestimmung des Korrekturfaktors K1 anhand einer oder mehrerer Messungen vor und/oder während des Ladevorgangs und anhand von Vergleichsdaten bestimmt wird, ob und in welchem Umfang sich eine oder mehrere Eigenschaften der zu ladenden Zelle seit einer vorhergehenden Bestimmung geändert haben.

3. Verfahren nach Anspruch 1 oder Anspruch 2, **dadurch gekennzeichnet, dass** zur Bestimmung des Korrekturfaktors K1 mindestens eine der Eigenschaften des Speichersystems aus der Gruppe mit
• einem Widerstand oder einer Widerstandsänderung des Speichersystems oder einer Komponente des Speichersystems,
• einer Leitfähigkeit oder einer Leitfähigkeitsänderung des Speichersystems oder einer Komponente des Speichersystems,
• einer Kapazität oder einer Kapazitätsänderung des Speichersystems oder einer Komponente des Speichersystems, und
• einer Temperatur oder einer Temperaturänderung des Speichersystems oder einer Komponente des Speichersystems bei definierten Lade- und/oder Entladebedingungen
untersucht werden.

4. Verfahren nach Anspruch 3, **gekennzeichnet durch** mindestens einen der folgenden Schritte:
• es wird eine Entladung des Speichersystems oder der Komponente des Speichersystems herbeigeführt, wobei als Spannungsabfall dU die Differenz zwischen Ausgangsspannung und Spannung nach definierter Entladezeit gemessen wird,
• aus dem gemessenen Spannungsabfall dU wird der Widerstand des Speichersystems oder der Komponente des Speichersystems abgeleitet,
• der Spannungsabfall dU und/oder der aus dU abgeleitete Widerstand wird zwecks Bestimmung des Korrekturfaktors K1 ins Verhältnis zu einem Spannungsabfall aus einer vorhergehenden Messung oder zu einem daraus abgeleiteten Widerstand gesetzt.

5. Verfahren nach einem der vorhergehenden Ansprüche, **dadurch gekennzeichnet, dass** die Bestimmung des Korrekturfaktors K2 und das Anwenden desselben auf die Zielspannung Uz während des Ladens, vorzugsweise kontinuierlich oder in zwei oder mehr Einzelschritten, erfolgen.

6. Verfahren nach einem der vorhergehenden Ansprüche, **dadurch gekennzeichnet, dass** mindestens ein oberer Temperaturschwellenwert und/oder mindestens ein unterer Temperaturschwellenwert festgelegt und die Temperatur des Speichersystems oder einer Komponente des Speichersystems gemessen wird.

7. Verfahren nach Anspruch 6, **dadurch gekennzeichnet, dass**
• bei Überschreitung eines der oberen Temperaturschwellenwerte bei einer der Messungen der Korrekturfaktor K1 unabhängig vom Ergebnis einer zuvor durchgeführten Bestimmung auf 1 gesetzt wird,
und/oder
• bei Überschreitung eines der oberen Temperaturschwellenwerte bei einer der Messungen der zu ermittelnde Korrekturfaktor K2 einer Korrelationstabelle entnommen oder mittels einer Korrekturformel errechnet wird.

8. Verfahren nach einem der Ansprüche 6 oder 7, **dadurch gekennzeichnet, dass** bei Überschreitung eines der oberen Temperaturschwellenwerte bei einer der Messungen die Zielspannung Uz abgesenkt wird, insbesondere um einen Wert im Bereich von - 1,2 mV / °C bis - 1,8 mV / °C, und/oder bei Unterschreitung eines der unteren Temperaturschwellenwerte bei einer der Messungen die Zielspannung Uz angehoben wird, insbesondere um einen Wert im Bereich von +1,2 mV / °C bis +1,8 mV / °C.

9. Verfahren nach einem der Ansprüche 6 bis 8, **dadurch gekennzeichnet, dass** der obere Temperaturschwellenwert im Bereich von 45 °C bis 80 °C und/oder dass der untere Temperaturschwellenwert im Bereich von 10 °C bis - 10 °C gewählt wird.

10. Verfahren nach einem der vorhergehenden Ansprüche, **dadurch gekennzeichnet, dass** das Laden des Speichersystems bis zum Erreichen der Zielspannung U_{ZK} bei einer konstanten Spannung U_{K1} oder bei einem konstantem Ladestrom I_{K} (constant current) erfolgt.

11. Verfahren nach Anspruch 10, **dadurch gekennzeichnet, dass** der Ladestrom I_{K} auf einen Wert im Bereich von 0.75 bis 10 C, insbesondere im Bereich von 0.5 bis 2 C, eingestellt wird.

12. Verfahren nach einem der vorhergehenden Ansprüche, **dadurch gekennzeichnet, dass** das Laden des Speichersystems nach Erreichen der Zielspannung U_{ZK} bei einer konstanten Spannung U_{K2} fortgesetzt wird.

13. Verfahren nach einem der vorhergehenden Ansprüche **dadurch gekennzeichnet, dass** zum Laden des Speichersystems
• eine Entladeschlussspannung U_{ES} festgelegt wird,
• ein Korrekturfaktor K3 für die Entladeschlussspannung U_{ES} bestimmt wird, der vom Alterungszustand (SOH) der mindestens einen elektrochemischen Zelle abhängt,
• der bestimmte Korrekturfaktor K3 auf die Entladeschlussspannung U_{ES} zwecks Ermittlung einer korrigierten Entladeschlussspannung U_{ESK} angewendet wird und
• das Laden des Speichersystems initiiert wird, wenn die korrigierte Entladeschlussspannung U_{ESK} an dem Speichersystem erreicht wird.

14. Verfahren nach Anspruch 13, **dadurch gekennzeichnet, dass** für die Zielspannung U_{ZK} und/oder die korrigierte Entladeschlussspannung U_{ESK} Schwellenwerte vorgegeben werden, die im Betrieb des Speichersystems nicht überschritten bzw. unterschritten werden sollen.

15. Vorrichtung zur Kontrolle und Durchführung des Ladevorgangs eines Speichersystems für elektrische Energie, das mindestens eine sekundäre elektrochemische Zelle umfasst, umfassend
• ein Mittel zum Festlegen einer Zielspannung Uz
und/oder
ein Mittel zum Festlegen einer Entladeschlussspannung U_{ES},
• ein Mittel zur Bestimmung eines Korrekturfaktors K1 für die Zielspannung Uz, der vom Alterungszustand (SOH) des zu ladenden Speichersystems abhängt,
und
ein Mittel zur Bestimmung eines Korrekturfaktors K2 für die Zielspannung Uz, der von der Umgebungstemperatur und/oder der Temperatur der zu ladenden Speichersystems oder einer Komponente des Speichersystems abhängt,
und/oder
ein Mittel zur Bestimmung eines Korrekturfaktors K3 für die Entladeschlussspannung U_{ES}, der vom Alterungszustand (SOH) des zu ladenden Speichersystems abhängt,
• ein Mittel zum Anwenden der ermittelten Korrekturfaktoren K1 und/oder K2 auf die Zielspannung Uz zwecks Ermittlung einer korrigierten Zielspannung U_{ZK},
und/oder
ein Mittel zum Anwenden des ermittelten Korrekturfaktors K3 auf die Entladeschlussspannung U_{ES} zwecks Ermittlung einer korrigierten Entladeschlussspannung U_{ESK}, und
• ein Mittel zum Laden des Speichersystems, bis die Zielspannung U_{ZK} an der Zelle erreicht wird und/oder wenn die korrigierte Entladeschlussspannung U_{ESK} an dem Speichersystem erreicht wird,
wobei die sekundäre elektrochemische Zelle eine negative Elektrode, eine positive Elektrode, einen porösen Separator, der die negative und die positive Elektrode voneinander trennt, einen wässrigen alkalischen Elektrolyten, mit dem die Elektroden und der Separator getränkt sind und ein Gehäuse, das die Elektroden, den Separator und den Elektrolyten umschließt, aufweist, und die negative Elektrode der elektrochemischen Zelle einen Stromableiter sowie Aktivkohle und/oder Graphen als kohlenstoffbasiertes Speichermaterial, das die Speicherung von elektrischer Ladung in der Elektrode durch Ausbildung einer elektrischen Doppelschicht ermöglicht, umfasst, wobei das kohlenstoffbasierte Speichermaterial in der negativen Elektrode bezogen auf das Gesamtgewicht der Elektrode in trockenem Zustand ohne Berücksichtigung des Stromableiters in einem Anteil zwischen 5 Gew.-% und 100 Gew.-% enthalten ist.

## Claims

1. Method for operating a rechargeable storage system for electrical energy that comprises at least one secondary electrochemical cell, **characterized in that**, to charge the storage system,
• a target voltage U_{z} is defined,
• a correction factor K1 that is dependent on the state of health (SOH) of the at least one electrochemical cell is determined for the target voltage U_{z},
• a correction factor K2 that is dependent on the ambient temperature and/or the temperature of the storage system or a component of the storage system is determined for the target voltage U_{z},
• the determined correction factors K1 and/or K2 are applied to the target voltage U_{z} for the purpose of ascertaining a corrected target voltage U_{ZK}, and
• the storage system is charged with a charging current and a charging voltage until the target voltage U_{ZK} is reached at the storage system,
wherein the secondary electrochemical cell has a negative electrode, a positive electrode, a porous separator that separates the negative electrode and the positive electrode from one another, an aqueous alkaline electrolyte, with which the electrodes and the separator are impregnated, and a housing that encloses the electrodes, the separator and the electrolyte, and the negative electrode of the electrochemical cell comprises a current output conductor and activated carbon and/or graphene as carbon-based storage material that, through formation of an electrical double layer, allows electrical charge to be stored in the electrode, wherein the carbon-based storage material in the negative electrode is present in a proportion of between 5% by weight and 100% by weight, based on the total weight of the electrode in the dry state without taking the current output conductor into consideration.

2. Method according to Claim 1, **characterized in that** the correction factor K1 is determined by using one or more measurements before and/or during the charging process, and by using comparison data, to determine whether and to what extent one or more properties of the cell to be charged have changed since a previous determination.

3. Method according to Claim 1 or Claim 2, **characterized in that** the correction factor K1 is determined by examining at least one of the properties of the storage system from the group comprising
• a resistance or a change in resistance of the storage system or a component of the storage system,
• a conductivity or a change in conductivity of the storage system or a component of the storage system,
• a capacitance or a change in capacitance of the storage system or a component of the storage system, and
• a temperature or a change in temperature of the storage system or a component of the storage system for defined charging and/or discharging conditions.

4. Method according to Claim 3, **characterized by** at least one of the following steps:
• discharging of the storage system or the component of the storage system is brought about, wherein the difference between the initial voltage and the voltage after a defined discharge time is measured as a voltage drop dU,
• the resistance of the storage system or the component of the storage system is derived from the measured voltage drop dU,
• the voltage drop dU and/or the resistance derived from dU is related to a voltage drop from a previous measurement, or a resistance derived therefrom, for the purpose of determining the correction factor K1.

5. Method according to one of the preceding claims, **characterized in that** the correction factor K2 is determined and applied to the target voltage U_{z} during charging, preferably continuously or in two or more individual steps.

6. Method according to one of the preceding claims, **characterized in that** at least one upper temperature threshold value and/or at least one lower temperature threshold value is defined and the temperature of the storage system or a component of the storage system is measured.

7. Method according to Claim 6, **characterized in that**,
• irrespective of the result of a determination performed previously, the correction factor K1 is set to 1 if one of the upper temperature threshold values is exceeded in one of the measurements,
and/or
• the correction factor K2 to be ascertained is taken from a correlation table or calculated by means of a correction formula if one of the upper temperature threshold values is exceeded in one of the measurements.

8. Method according to either of Claims 6 and 7, **characterized in that** the target voltage U_{z} is lowered, in particular by a value in the range from -1.2 mV/°C to -1.8 mV/°C, if one of the upper temperature threshold values is exceeded in one of the measurements, and/or the target voltage U_{z} is raised, in particular by a value in the range from +1.2 mV/°C to +1.8 mV/°C, if one of the lower temperature threshold values is not reached in one of the measurements.

9. Method according to one of Claims 6 to 8, **characterized in that** the upper temperature threshold value is selected to be in the range from 45°C to 80°C and/or **in that** the lower temperature threshold value is selected to be in the range from 10°C to -10°C.

10. Method according to one of the preceding claims, **characterized in that** the storage system is charged with a constant voltage U_{K1} or with a constant charging current I_{K} (constant current) until the target voltage U_{ZK} is reached.

11. Method according to Claim 10, **characterized in that** the charging current I_{K} is set to a value in the range from 0.5 to 10 C, in particular in the range from 0.5 to 2 C.

12. Method according to one of the preceding claims, **characterized in that** the storage system continues to be charged with a constant voltage U_{K2} after the target voltage U_{ZK} has been reached.

13. Method according to one of the preceding claims, **characterized in that**, to charge the storage system,
• an end-of-discharge voltage U_{ES} is defined,
• a correction factor K3 that is dependent on the state of health (SOH) of the at least one electrochemical cell is determined for the end-of-discharge voltage U_{ES},
• the determined correction factor K3 is applied to the end-of-discharge voltage U_{ES} for the purpose of ascertaining a corrected end-of-discharge voltage U_{ESK}, and
• charging of the storage system is initiated when the corrected end-of-discharge voltage U_{ESK} is reached at the storage system.

14. Method according to Claim 13, **characterized in that** threshold values that should not be transgressed during operation of the storage system are predefined for the target voltage U_{ZK} and/or the corrected end-of-discharge voltage U_{ESK}.

15. Device for monitoring and performing the charging process for a storage system for electrical energy that comprises at least one secondary electrochemical cell, comprising
• a means for defining a target voltage U_{z},
and/or
a means for defining an end-of-discharge voltage U_{ES},
• a means for determining for the target voltage U_{z} a correction factor K1 that is dependent on the state of health (SOH) of the storage system to be charged, and
a means for determining for the target voltage U_{z} a correction factor K2 that is dependent on the ambient temperature and/or the temperature of the storage system to be charged or a component of the storage system,
and/or
a means for determining for the end-of-discharge voltage U_{ES} a correction factor K3 that is dependent on the state of health (SOH) of the storage system to be charged,
• a means for applying the ascertained correction factors K1 and/or K2 to the target voltage U_{Z} for the purpose of ascertaining a corrected target voltage U_{ZK},
and/or
a means for applying the ascertained correction factor K3 to the end-of-discharge voltage U_{ES} for the purpose of ascertaining a corrected end-of-discharge voltage U_{ESK}, and
• a means for charging the storage system until the target voltage U_{ZK} is reached at the cell and/or when the corrected end-of-discharge voltage U_{ESK} is reached at the storage system,
wherein the secondary electrochemical cell has a negative electrode, a positive electrode, a porous separator that separates the negative electrode and the positive electrode from one another, an aqueous alkaline electrolyte, with which the electrodes and the separator are impregnated, and a housing that encloses the electrodes, the separator and the electrolyte, and the negative electrode of the electrochemical cell comprises a current output conductor and activated carbon and/or graphene as carbon-based storage material that, through formation of an electrical double layer, allows electrical charge to be stored in the electrode, wherein the carbon-based storage material in the negative electrode is present in a proportion of between 5% by weight and 100% by weight, based on the total weight of the electrode in the dry state without taking the current output conductor into consideration.

## Revendications

1. Procédé permettant de faire fonctionner un système de stockage rechargeable d'énergie électrique qui comprend au moins une cellule électrochimique secondaire, **caractérisé en ce que** pour le chargement du système de stockage
• une tension cible U_{Z} est fixée,
• un facteur de correction K1 pour la tension cible U_{Z} est déterminé, qui dépend de l'état de vieillissement (SOH) de ladite au moins une cellule électrochimique,
• un facteur de correction K2 pour la tension cible U_{Z} est déterminé, qui dépend de la température ambiante et/ou de la température du système de stockage ou d'un composant du système de stockage,
• les facteurs de correction K1 et/ou K2 déterminés sont appliqués à la tension cible U_{Z} en vue d'établir une tension cible corrigée U_{ZK}, et
• le système de stockage est chargé avec un courant de charge et une tension de charge jusqu'à ce que la tension cible U_{ZK} soit atteinte au niveau du système de stockage,
la cellule électrochimique secondaire présentant une électrode négative, une électrode positive, un séparateur poreux qui sépare l'électrode négative et l'électrode positive l'une de l'autre, un électrolyte alcalin aqueux dont les électrodes et le séparateur sont imprégnés, et un boîtier qui enferme les électrodes, le séparateur et l'électrolyte, et l'électrode négative de la cellule électrochimique comprenant un collecteur de courant ainsi que du charbon actif et/ou du graphène comme matériau de stockage à base de carbone qui permet de stocker une charge électrique dans l'électrode en réalisant une double couche électrique, le matériau de stockage à base de carbone étant contenu dans l'électrode négative, par rapport au poids total de l'électrode à l'état sec sans tenir compte du collecteur de courant, dans un pourcentage compris entre 5 % en poids et 100 % en poids.

2. Procédé selon la revendication 1, **caractérisé en ce que** pour déterminer le facteur de correction K1 à l'aide d'une ou de plusieurs mesures avant et/ou pendant le processus de charge et à l'aide de données de comparaison, il est déterminé si et dans quelle mesure une ou plusieurs propriétés de la cellule à charger a ou ont changé depuis une détermination précédente.

3. Procédé selon la revendication 1 ou 2, **caractérisé en ce que** pour déterminer le facteur de correction K1, au moins l'une des propriétés du système de stockage du groupe comprenant
• une résistance ou une variation de résistance du système de stockage ou d'un composant du système de stockage,
• une conductibilité ou une variation de conductibilité du système de stockage ou d'un composant du système de stockage,
• une capacité ou une variation de capacité du système de stockage ou d'un composant du système de stockage, et
• une température ou une variation de température du système de stockage ou d'un composant du système de stockage sous des conditions de chargement et/ou déchargement définies,
est examinée.

4. Procédé selon la revendication 3, **caractérisé par** au moins l'une des étapes suivantes :
• un déchargement du système de stockage ou du composant du système de stockage est provoqué, la différence entre la tension de sortie et la tension après un temps de déchargement défini étant mesurée comme la chute de tension dU,
• la résistance du système de stockage ou du composant du système de stockage est dérivée de la chute de tension mesurée dU,
• la chute de tension dU et/ou la résistance dérivée de dU sont mises en relation avec une chute de tension issue d'une mesure précédente ou avec une résistance dérivée de celle-ci en vue de déterminer le facteur de correction K1.

5. Procédé selon l'une quelconque des revendications précédentes, **caractérisé en ce que** la détermination du facteur de correction K2 et l'application de celui-ci à la tension cible U_{Z} pendant le chargement ont lieu de préférence en continu ou en deux ou plusieurs étapes individuelles.

6. Procédé selon l'une quelconque des revendications précédentes, **caractérisé en ce qu'**au moins une valeur seuil de température supérieure et/ou au moins une valeur seuil de température inférieure est/sont fixée(s), et la température du système de stockage ou d'un composant du système de stockage est mesurée.

7. Procédé selon la revendication 6, **caractérisé en ce que**
• en cas de dépassement d'une des valeurs seuil de température supérieures lors d'une des mesures, le facteur de correction K1 est réglé sur 1 indépendamment du résultat d'une détermination effectuée précédemment, et/ou
• en cas de dépassement d'une des valeurs seuil de température supérieures lors d'une des mesures, le facteur de correction K2 à établir est extrait d'une table de corrélation ou est calculé au moyen d'une formule de correction.

8. Procédé selon l'une quelconque des revendications 6 ou 7, **caractérisé en ce qu'**en cas de dépassement d'une des valeurs seuil de température supérieures lors d'une des mesures, la tension cible U_{Z} est abaissée, en particulier d'une valeur dans la plage de -1,2 mV/°C à -1,8 mV/°C, et/ou en cas de soupassement d'une des valeurs seuil de température inférieures lors d'une des mesures, la tension cible U_{Z} est relevée, en particulier d'une valeur dans la plage de +1,2 mV/°C à +1,8 mV/°C.

9. Procédé selon l'une quelconque des revendications 6 à 8, **caractérisé en ce que** la valeur seuil de température supérieure est sélectionnée dans la plage de 45 °C à 80 °C, et/ou **en ce que** la valeur seuil de température inférieure est sélectionnée dans la plage de 10 °C à -10 °C.

10. Procédé selon l'une quelconque des revendications précédentes, **caractérisé en ce que** le chargement du système de stockage jusqu'à ce que la tension cible U_{ZK} soit atteinte est effectué avec une tension constante U_{K1} ou avec un courant de charge constant I_{K} (« constant current »).

11. Procédé selon la revendication 10, **caractérisé en ce que** le courant de charge I_{K} est réglé sur une valeur dans la plage de 0,5 à 10 C, en particulier dans la plage de 0,5 à 2 C.

12. Procédé selon l'une quelconque des revendications précédentes, **caractérisé en ce que** le chargement du système de stockage après que la tension cible U_{ZK} est atteinte est poursuivie avec une tension constante U_{K2}.

13. Procédé selon l'une quelconque des revendications précédentes, **caractérisé en ce que** pour le chargement du système de stockage
• une tension de fin de décharge U_{ES} est fixée,
• un facteur de correction K3 est déterminé pour la tension de fin de décharge U_{ES}, qui dépend de l'état de vieillissement (SOH) de ladite au moins une cellule électrochimique,
• le facteur de correction K3 déterminé est appliqué à la tension de fin de décharge U_{ES} en vue de d'établir une tension de fin de décharge corrigée U_{ESK}, et
• le chargement du système de stockage est lancé si la tension de fin de décharge corrigée U_{ESK} est atteinte au niveau du système de stockage.

14. Procédé selon la revendication 13, **caractérisé en ce que** pour la tension cible U_{ZK} et/ou la tension de fin de décharge corrigée U_{ESK}, des valeurs seuil sont prédéfinies qui ne doivent pas être dépassées ou soupassées en cours de fonctionnement du système de stockage.

15. Dispositif de contrôle et d'exécution d'un processus de charge d'un système de stockage d'énergie électrique, qui comprend au moins une cellule électrochimique secondaire, comprenant
• un moyen pour fixer une tension cible U_{Z},
et/ou
un moyen pour fixer une tension de fin de décharge U_{ES},
• un moyen pour déterminer un facteur de correction K1 pour la tension cible U_{Z}, qui dépend de l'état de vieillissement (SOH) du système de stockage à charger,
et
un moyen pour déterminer un facteur de correction K2 pour la tension cible U_{Z}, qui dépend de la température ambiante et/ou de la température du système de stockage ou d'un composant du système de stockage,
et/ou
un moyen pour déterminer un facteur de correction K3 pour la tension de fin de décharge U_{ES}, qui dépend de l'état de vieillissement (SOH) du système de stockage à charger,
• un moyen pour appliquer les facteurs de correction déterminés K1 et/ou K2 à la tension cible U_{Z} en vue d'établir une tension cible corrigée U_{ZK},
et/ou
un moyen pour appliquer le facteur de correction établi K3 à la tension de fin de décharge U_{ES} en vue d'établir une tension de fin de décharge corrigée U_{ESK}, et
• un moyen pour charger le système de stockage jusqu'à ce que la tension cible U_{ZK} soit atteinte au niveau de la cellule et/ou si la tension de fin de décharge corrigée U_{ESK} est atteinte au niveau du système de stockage,
la cellule électrochimique secondaire présentant une électrode négative, une électrode positive, un séparateur poreux qui sépare l'électrode négative et l'électrode positive l'une de l'autre, un électrolyte alcalin aqueux dont les électrodes et le séparateur sont imprégnés, et un boîtier qui enferme les électrodes, le séparateur et l'électrolyte, et l'électrode négative de la cellule électrochimique comprenant un collecteur de courant ainsi que du charbon actif et/ou du graphène comme matériau de stockage à base de carbone qui permet de stocker une charge électrique dans l'électrode en réalisant une double couche électrique, le matériau de stockage à base de carbone étant contenu dans l'électrode négative, par rapport au poids total de l'électrode à l'état sec sans tenir compte du collecteur de courant, dans un pourcentage compris entre 5 % en poids et 100 % en poids.
